# FASCICULE DE BREVET EUROPEEN

(11) **EP 3 519 604 B1**
(45) Date de publication et mention de la délivrance du brevet: **29.07.2020**
(21) Numéro de dépôt: 17793686.1
(22) Date de dépôt: 28.09.2017
(51) Int. Cl.: C23C 16/02, C23C 16/04, C23C 16/10, C23C 16/32, C23C 16/34, C23C 16/36, C23C 28/00, G21C 3/07, C23C 16/18, C23C 16/448, C23C 16/56

(54) **COMPOSANT NUCLÉAIRE A SUBSTRAT METALLIQUE, PROCÉDÉ DE FABRICATION PAR DLI-MOCVD ET UTILISATIONS CONTRE L'OXYDATION/HYDRURATION**
NUKLEARE KOMPONENTE MIT EINEM METALLSUBSTRAT, VERFAHREN ZUR HERSTELLUNG DAVON MITTELS DLI-MOCVD UND VERWENDUNGEN DAVON ZUR OXIDATION/HYDRIDIERUNG
NUCLEAR COMPONENT WITH A METAL SUBSTRATE, METHOD FOR THE PRODUCTION THEREOF BY DLI-MOCVD, AND USES OF SAME FOR CONTROLLING OXIDATION/HYDRIDATION

(30) Priorité: 28.09.2016 FR 1659274; 28.09.2016 FR 1659275
(43) Date de publication de la demande: 07.08.2019
(73) Titulaire: Commissariat à l'Énergie Atomique et aux Énergies Alternatives, 75015 Paris (FR)
(72) Inventeur: SCHUSTER, Frédéric, 78100 St Germain-en-Laye (FR); LOMELLO, Fernando, 91190 Gif-sur-Yvette (FR); MAURY, Francis, 31670 Labege (FR); MICHAU, Alexandre, 31400 Toulouse (FR); BOICHOT, Raphaël, 38420 Domène (FR); PONS, Michel, 38700 La Tronche (FR)
(74) Mandataire: Brevalex
(86) Numéro de dépôt international: PCT/FR2017/052655
(87) Numéro de publication internationale: WO 2018/060641

(56) Documents cités:
- EP-A1- 0 387 113
- FR-A1- 2 612 946
- FR-A1- 2 904 006
- FR-A1- 2 989 923
- FR-A1- 2 992 331
- FR-A1- 3 025 929
- MAURY F ET AL: "Multilayer chromium based coatings grown by atmospheric pressure direct liquid injection CVD", SURFACE AND COATINGS TECHNOLOGY, ELSEVIER BV, AMSTERDAM, NL, vol. 204, no. 6-7, 25 décembre 2009 (2009-12-25), pages 983-987, XP026770374, ISSN: 0257-8972, DOI: 10.1016/J.SURFCOAT.2009.04.020 [extrait le 2009-04-23]

## Description

### DOMAINE TECHNIQUE

La présente invention appartient au domaine des matériaux mis en œuvre dans le domaine nucléaire, en particulier les matériaux destinés à résister au mieux aux conditions physico-chimiques rencontrées en conditions nominales et lors d'un accident de réacteur nucléaire, tel que par exemple un Réacteur à Eau sous Pression (REP) ou un Réacteur à Eau Bouillante (REB).

L'invention concerne plus particulièrement un composant nucléaire, son procédé de fabrication et ses utilisations contre l'oxydation et/ou l'hydruration.

### ARRIERE-PLAN TECHNIQUE

L'alliage de zirconium constitutif des gaines de combustible nucléaire actuelles s'oxyde au contact de l'eau constituant le caloporteur des réacteurs nucléaires REP ou REB.

L'oxyde formé étant fragile et la prise d'hydrogène associée à l'oxydation conduisant à la précipitation d'hydrures de zirconium qui sont fragilisants, la durée de vie des gaines est en partie limitée par l'épaisseur maximale d'oxyde acceptable et la teneur en hydrogène absorbé associé. Pour garantir de bonnes propriétés mécaniques résiduelles de la gaine visant à assurer un confinement optimal du combustible nucléaire, l'épaisseur résiduelle d'alliage de zirconium sain et ductile doit être suffisante et/ou la fraction d'hydrures suffisamment limitée pour garantir de bonnes propriétés mécaniques résiduelles de la gaine visant à assurer un confinement optimal du combustible nucléaire.

La possibilité de limiter ou de retarder une telle oxydation et/ou l'hydruration peut donc s'avérer cruciale en conditions accidentelles.

Ces conditions sont par exemple atteintes dans le cas de scénarios hypothétiques accidentels type « RIA » (pour "Reactivity Insertion Accident") ou « APRP » (Accident de Perte de Réfrigérant Primaire), voire en conditions de dénoyage de la piscine de stockage de combustible usé. Elles se caractérisent notamment par de hautes températures qui sont généralement supérieures à 700 °C, en particulier comprises entre 800 °C et 1200 °C, et qui peuvent être atteintes avec une vitesse élevée de montée en température. À de telles températures, le caloporteur est sous forme de vapeur d'eau.

L'oxydation en conditions accidentelles est beaucoup plus critique qu'en conditions de fonctionnement normal du réacteur nucléaire, car la détérioration du gainage, première barrière de confinement du combustible, est plus rapide et les risques associés plus importants. Ces risques sont notamment les suivants :
- dégagement d'hydrogène ;
- fragilisation du gainage à haute température, par l'oxydation voire, dans certaines conditions, l'hydruration du gainage ;
- fragilisation du gainage à la trempe, provoquée par la diminution brutale de température lors de l'apport massif d'eau pour la mise en sécurité du cœur du réacteur nucléaire ;
- faible tenue mécanique du gainage après la trempe ou le refroidissement, en cas notamment d'opérations de manutention après accident, de répliques de séismes,....

Compte tenu de ces risques, il est essentiel de limiter au mieux l'oxydation et/ou l'hydruration du gainage à haute température, voire à très haute température, afin d'améliorer la sûreté des réacteurs nucléaires utilisant notamment l'eau comme caloporteur.

Les très hautes températures se situent à l'extrême voire au-delà de celles des hautes températures comprises entre 700 °C et 1200 °C qui sont fixées par les conditions réglementaires accidentelles.

Or, les critères réglementaires régissant les accidents de dimensionnement selon le scénario de type « APRP » défini dès les années 1970 imposaient que la température maximale de la gaine ne dépasse pas 1204 °C (2200 °F) et un taux d'oxydation « ECR » maximal de 17 %.

Le taux d'oxydation « ECR » (« Equivalent Cladding Reacted ») est le pourcentage d'épaisseur de gaine métallique transformée en zircone (ZrO₂) résultant de l'oxydation du zirconium contenu dans la gaine de combustible nucléaire, en faisant l'hypothèse que tout l'oxygène qui a réagi forme de la zircone stœchiométrique.

Pour tenir compte de l'effet fragilisant supplémentaire lié à l'hydruration en service du gainage, ce taux d'oxydation « ECR » résiduel acceptable peut désormais être largement inférieur à 17 % dans certaines conditions, telles que par exemple un gainage hydruré en service jusqu'à plusieurs centaines de ppm massique, ce qui correspond en pratique à une durée d'oxydation du gainage qui ne doit pas excéder quelques minutes à 1200 °C.

Une amélioration de la résistance à l'oxydation et/ou l'hydruration à très haute température permettrait avantageusement d'obtenir des marges de sécurité supplémentaires, notamment en évitant ou retardant d'autant plus la détérioration du gainage en cas d'aggravation ou de persistance de la situation accidentelle.

Des procédés de fabrication et des composants nucléaires connus de l'art antérieur sont décrits dans FR3025929, FR2992331, FR2989923, EP0387113 ou FR2904006.

### EXPOSE DE L'INVENTION

Un des buts de l'invention est donc d'éviter ou d'atténuer un ou plusieurs des inconvénients décrits ci-dessus, en proposant un composant nucléaire et son procédé de fabrication qui améliore la résistance à l'oxydation et/ou l'hydruration, notamment en présence de vapeur d'eau.

Un autre but de l'invention peut être d'améliorer cette résistance à l'oxydation et/ou l'hydruration à haute température entre 700 °C et 1200 °C, voire à très haute température au-delà de 1200 °C ; notamment lorsque ces températures sont atteintes avec une vitesse de montée en température qui est comprise entre 0,1 °C/secondes et 300 °C/secondes.

Un autre but de l'invention peut être d'améliorer la durée de la résistance à l'oxydation et/ou l'hydruration, durée au-delà de laquelle l'intégrité du composant nucléaire, en particulier le confinement du combustible nucléaire, n'est plus assurée.

Un autre but de l'invention peut être d'améliorer le potentiel d'industrialisation du procédé de fabrication, notamment en proposant un procédé à la fois souple d'utilisation, économique et plus respectueux de l'environnement.

La présente invention concerne ainsi un procédé de fabrication d'un composant nucléaire par la méthode décrite dans la revendication 1.

En comparaison avec les procédés de l'état de la technique, le procédé de fabrication de l'invention améliore notamment la résistance d'un composant nucléaire vis-à-vis de l'oxydation et/ou l'hydruration, tout en offrant un procédé de dépôt à fort potentiel d'industrialisation accru par la possibilité de recyclage.

Le procédé de fabrication de l'invention utilise une méthode de dépôt chimique en phase vapeur d'un composé organométallique par injection liquide directe (dite « DLI-MOCVD » selon l'acronyme anglais pour « *Direct Liquid Injection* - *Metal Organic Chemical Vapor Deposition* »). Cette méthode est décrite par exemple dans les documents suivants : « F. Maury, A. Douard, S. Delclos, D. Samelor, C. Tendero; Multilayer chromium based coatings grown by atmospheric pressure direct liquid injection CVD Surface and Coatings Technology, 204 (2009) 983-987 » (référence [1]), « A. Douard, F. Maury ; Nanocrystalline chromium-based coatings deposited by DLI-MOCVD under atmospheric pressure from Cr(CO)6 ; Surface and Coatings Technology, 200 (2006) 6267-6271 » (référence [2]), WO 2008009714 (référence [3]) et WO 2008009715 (référence [4]).

Pour rappel, le principe de la technique DLI-MOCVD est d'introduire directement dans une enceinte de dépôt chimique en phase vapeur, en régime continu ou pulsé, un précurseur du métal à déposer sous forme vaporisée.

Dans ce but, à partir d'un réservoir d'alimentation sous pression (par exemple sous une pression de 3.10⁵ Pa d'un gaz inerte), une solution mère contenant au moins un composé organométallique en tant que précurseur est introduite dans un évaporateur. Elle est ensuite fractionnée en microgouttelettes pour former un aérosol qui est vaporisé de façon flash. L'évaporation flash consiste à vaporiser de manière rapide un composé en dehors des conditions de pression et de température prévues par sa loi de pression de vapeur saturante. L'évaporateur est chauffé à une température telle que le précurseur et son solvant sont vaporisés, sans toutefois provoquer de décomposition à ce stade. La température est commodément comprise entre la température d'ébullition du solvant et la température de décomposition du précurseur et accessoirement celle du solvant, par exemple de 200 °C.

Les paramètres d'injection de la solution mère sont de préférence fixés à l'aide d'un programme informatique. Ils sont ajustés de manière à obtenir un brouillard de gouttelettes très fines et nombreuses, afin d'obtenir une évaporation flash satisfaisante sous pression réduite. L'injection liquide constitue ainsi une source bien contrôlée de précurseur organométallique, ne limitant pas les possibilités d'optimisation des paramètres du procédé de dépôt du revêtement.

Cette flexibilité dans la formulation de la solution mère permet de déposer une grande variété de revêtements avec un seul dispositif de dépôt physique en phase vapeur. La composition, la structure, la géométrie et les caractéristiques physico-chimiques d'un revêtement peuvent en particulier être déclinées selon de nombreuses variantes, notamment pour un revêtement tel qu'une couche protectrice, une couche intercalaire, un feuillard interne.

La solution mère vaporisée est entraînée par un flux de gaz inerte de l'évaporateur vers la zone de dépôt du réacteur dans lequel a été placé le substrat à recouvrir. Le gaz vecteur utilisé est de préférence préchauffé à la température de l'évaporateur pour obtenir une vaporisation plus efficace. Il est inerte pour ne pas réagir avec les réactifs en présence, en les oxydant par exemple. L'azote est généralement choisi pour son faible coût, mais l'hélium bénéficiant d'une meilleure conductivité thermique ou l'argon dont le pouvoir de protection est supérieur peut aussi être employé.

Selon le procédé de fabrication de l'invention, l'enceinte du réacteur de dépôt chimique en phase vapeur est chauffée à une température de dépôt comprise entre 300 °C et 600 °C. Pour cet intervalle de températures, le précurseur organométallique, en particulier de type bis (arène) métal, se décompose sans dégrader le solvant, afin d'éviter au mieux l'obtention de sous-produits réactionnels susceptibles de polluer l'enceinte en se déposant sur les parois du réacteur voire sur le substrat. Si le substrat à recouvrir est métallique, la température peut être limitée à la température de tenue du métal afin d'éviter sa déformation ou transformation de phase éventuelle. Par exemple, lorsque le substrat est constitué d'un alliage de zirconium, la température de dépôt peut être comprise entre 350 °C et 550 °C. La température de dépôt réduite pour le procédé de DLI-MOCVD est un avantage comparé à d'autres procédés CVD de chromisation en phase vapeur qui utilisent des halogénures de métaux de transitions gazeux et fonctionnent à des températures pouvant atteindre 900 °C.

Le réacteur de dépôt chimique en phase vapeur est placé sous pression réduite, à laquelle sont réalisées les principales étapes du dépôt, depuis la vaporisation de la solution mère, jusqu'à la collecte éventuelle de l'effluent obtenu à l'issue du procédé de fabrication. La pression réduite est généralement de quelques Torr à quelques dizaines de Torr. Il s'agit donc de pressions modérément réduites au regard des pressions d'environ 10⁻³ Torr à 10⁻⁴ Torr des procédés PVD industriels qui nécessitent des équipements de vide poussé.

Un des avantages du procédé de dépôt DLI-MOCVD pour revêtir un composant nucléaire d'une couche protectrice est que cette dernière peut être déposée sur la surface interne et/ou la surface externe du substrat revêtu ou non d'une couche intercalaire.

La protection de la couche interne d'un composant nucléaire avec le procédé de fabrication de l'invention est particulièrement intéressante lorsque le substrat à revêtir a une dimension importante, par exemple dans le cas d'une gaine tubulaire de combustible nucléaire d'un diamètre de 1 cm et d'une longueur d'environ 4 m. Elle répond en partie aux problèmes d'oxydation et/ou d'hydruration rencontrés en milieu nucléaire.

En effet, à titre d'exemple, lors d'un scénario d'accident de perte de réfrigérant primaire (APRP) dans les réacteurs de génération II et III, une gaine de combustible en alliage de zirconium est soumise à une brusque élévation de température et de pression interne qui conduisent au ballonnement et à l'oxydation accélérée de la gaine. La combinaison de ces deux phénomènes peut mener à l'éclatement de la gaine, et donc à une rupture de confinement du combustible nucléaire et des produits de fission qu'elle contient.

La surface interne de la gaine ainsi mise à nue est particulièrement sensible à l'oxydation et à une hydruration secondaire, à savoir une hydruration massive localisée qui résulte de l'appauvrissement en oxygène de l'atmosphère de vapeur d'eau par effet de confinement. La gaine peut alors se dégrader par fissuration lors de la trempe causée par le renoyage du cœur accidenté, voire lors de sollicitations mécaniques post-trempe (répliques de séisme, manutention, ...). Cette dégradation peut éventuellement conduire à une perte d'efficacité du refroidissement des assemblages combustible et évoluer vers une situation dégradée non maîtrisée (« accidents graves »).

Le revêtement de la surface interne d'une gaine de combustible nucléaire avec au moins une couche protectrice aide à limiter, retarder voire éviter l'oxydation interne et/ou l'hydruration secondaire en conditions APRP.

Il présente également un intérêt pour lutter contre l'hydruration secondaire en conditions nominales en cas de perçage incidentel de la gaine et contre la problématique de l'interaction pastille de combustible-gaine.

Le substrat sur lequel est déposée au moins une couche protectrice avec le procédé de fabrication de l'invention est composé d'un métal ou d'un de ses alliages de base.

Préférentiellement, le substrat est composé de zirconium ou d'un alliage à base de zirconium. L'alliage à base de zirconium peut comprendre en poids :
- de 0 % à 3 % de niobium ;
- de 0 % à 2 % d'étain ;
- de 0 % à 0,5 % de fer ;
- de 0 % à 0,2 % de chrome ;
- de 0 % à 0,2 % de nickel ;
- de 0 % à 0,2 % de cuivre ;
- de 0 % à 1 % de vanadium ;
- de 0 % à 1 % de molybdène ;
- de 0,05 % à 0,2 % d'oxygène.

L'alliage de zirconium peut en particulier être choisi parmi un alliage répondant aux contraintes du domaine nucléaire, par exemple le Zircaloy-2, le Zircaloy-4, le Zirlo™, l'Optimized-Zirlo™ ou le M5™. Les compositions de de ces alliages sont telles qu'ils comprennent en poids, par exemple :
- alliage Zircaloy-2 : 1,20 % à 1,70 % de Sn ; 0,07 % à 0,20 % de Fe ; 0,05 % à 1,15 % de Cr ; 0,03 % à 0,08 % de Ni ; 900 ppm à 1500 ppm d'O ; le reste de zirconium.
- alliage Zircaloy-4 : 1,20 % à 1,70 % de Sn ; 0,18 % à 0,24 % de Fe ; 0,07 % à 1,13 % de Cr ; 900 ppm à 1500 ppm d'O ; moins de 0,007 % de Ni ; le reste de zirconium.
- alliage Zirlo™ : 0,5 % à 2,0 % de Nb ; 0,7 % à 1,5 % de Sn ; 0,07 % à 0,28 % d'au moins un élément choisi parmi Fe, Ni, Cr ; jusqu'à 200 ppm de C ; le reste de zirconium.
- alliage Optimized-Zirlo™ : 0,8 % à 1,2 % de Nb ; 0,6 % à 0,9 % de Sn ; 0,090 % à 0,13 % de Fe ; 0,105 % à 0,145 % d'O ; le reste de zirconium.
- alliage M5™ : 0,8 % à 1,2 % de Nb ; 0,090 % à 0,149 % d'O ; 200 ppm à 1000 ppm de Fe ; le reste de zirconium.

Préférentiellement, l'alliage à base de zirconium est le Zircaloy-2 ou le Zircaloy-4.

Selon une géométrie particulière, le composant nucléaire fabriqué avec le procédé de l'invention peut comprendre une couche intercalaire positionnée entre le substrat et au moins une couche protectrice.

Dans ce mode de réalisation, le support est formé par la combinaison du substrat et de la couche intercalaire.

La couche intercalaire peut remplir la fonction de barrière de diffusion.

Lorsque le substrat comprend du zirconium ou un alliage de zirconium, la couche intercalaire constitue en particulier une barrière de diffusion qui limite voire empêche :
- la diffusion du chrome de la couche externe vers la couche interne à base de zirconium, ce qui conduit à une consommation accélérée de la ou des couche(s) externe(s) en plus de son oxydation en chromine ;
- la formation d'un eutectique au-delà de 1330 °C environ, ce qui peut potentiellement nuire à la tenue mécanique du composant et sa capacité à être refroidie

La couche intercalaire peut être déposée sur le substrat avec une grande variété de méthodes de dépôt, plus particulièrement en réalisant un dépôt par DLI-MOCVD ou par dépôt chimique en phase vapeur (CVD) assisté par plasma, sur la surface externe substrat et/ou sur sa surface interne.

Ces deux méthodes peuvent être utilisées lorsque la couche intercalaire est déposée sur la surface externe du substrat.

Par contre, seul un dépôt par DLI-MOCVD permet de recouvrir la surface interne du substrat, généralement lorsque la couche intercalaire est composée d'une matière métallique. Les conditions opératoires de dépôt par DLI-MOCVD sont alors celles décrites par ailleurs dans la présente description. En particulier, le précurseur comprenant une matière intercalaire choisie parmi le chrome, le tantale, le molybdène, le tungstène, le niobium ou le vanadium peut être de type bis (arène) selon les variantes indiquées dans la présente description.

La méthode de dépôt de CVD assistée par plasma est quant à elle seulement utilisée pour un dépôt sur la surface externe du substrat, généralement lorsque la couche intercalaire est composée d'une matière céramique. Préférentiellement, la couche intercalaire est alors déposée sur la surface externe du substrat en réalisant le dépôt CVD assisté par plasma à partir d'un mélange comprenant au moins un halogénure de titane, d'aluminium ou de silicium et un précurseur gazeux de l'azote, comme illustré par exemple par le document « S. Anderbouhr, V. Ghetta, E. Blanquet, C. Chabrol, F. Schuster, C. Bernard, R. Madar ; LPCVD and PACVD (Ti,Al)N films: morphology and mechanical properties ; Surface and Coatings Technology, Volume 115, Issues 2-3, 18 July 1999, Pages 103-110 » (référence [5]).

Préférentiellement, l'halogénure de titane, d'aluminium ou de silicium est un chlorure de titane, d'aluminium ou de silicium. Il est choisi par exemple parmi TiCl₄, AlCl₃, SiCl₄ ou leurs mélanges.

Préférentiellement, la couche intercalaire peut comprendre au moins une matière intercalaire choisie parmi le chrome, le tantale, le molybdène, le tungstène, le niobium, le vanadium, leurs alliages, un nitrure de titane, un carbonitrure de titane, un nitrure mixte titane silicium, un carbure mixte titane silicium, un carbonitrure mixte titane silicium, un nitrure mixte titane aluminium ou leurs mélanges.

La matière intercalaire composée d'un nitrure de titane, un carbonitrure de titane, un nitrure mixte titane silicium, un carbure mixte titane silicium, un carbonitrure mixte titane silicium ou un nitrure mixte titane aluminium est une matière intercalaire céramique : chacune de ces matières est en général notée respectivement TiN, TiCN, TiSiN, TiSiC, TiSiCN ou TiAlN, sans que cela implique une quelconque stœchiométrie ; les atomes d'azote, de carbone, de silicium et d'aluminium étant généralement en insertion dans la matrice métallique de titane.

Préférentiellement, l'épaisseur de la couche intercalaire est de 1 µm à 5 µm.

Selon une autre géométrie particulière, le composant nucléaire fabriqué avec le procédé de l'invention peut comprendre en outre un feuillard interne placé sur la surface interne dudit support. Ce feuillard interne est appelé « liner » en anglais et joue généralement le rôle de barrière de diffusion ou améliore la robustesse du composant nucléaire vis-à-vis d'éventuelles interactions chimiques ou mécaniques.

Ladite au moins une couche protectrice peut être une couche protectrice externe qui revêt la surface externe dudit support et/ou, lorsque le composant nucléaire comprend un volume interne ouvert ou non, une couche protectrice interne qui revêt la surface interne dudit support revêtu ou non du feuillard interne.

Un composant nucléaire qui comprend un volume interne est par exemple une gaine de combustible nucléaire, un tube guide, un combustible à plaque (dont le volume interne n'est pas ouvert, ce composant pouvant néanmoins être fabriqué par l'assemblage de plusieurs parties pouvant comprendre une surface sur laquelle on dépose la couche protectrice interne, ces surfaces formant - après assemblage des parties - la surface interne du support recouverte de la couche protectrice), une barre d'absorbant.

Le feuillard interne ne constitue pas forcément un revêtement : il peut s'agir d'une pièce qui est assemblée ou emboîtée ultérieurement dans le composant nucléaire. Il peut également être obtenu par co-filage à chaud lors de la fabrication du substrat.

Alternativement, le feuillard interne peut être déposé, à une température de dépôt comprise entre 200 °C et 400 °C, sur la surface interne du support par dépôt chimique en phase vapeur d'un composé organométallique (MOCVD) ou DLI-MOCVD avec pour précurseur(s) un amide de titane et en outre un précurseur comprenant du silicium, un précurseur comprenant de l'aluminium et/ou un additif liquide comprenant de l'azote en tant que précurseur si la matière composant le feuillard interne comprend respectivement du silicium, de l'aluminium et/ou de l'azote.

La méthode de dépôt par MOCVD est décrite par exemple pour l'homologue du titane qui peut être le chrome pour ce procédé MOCVD dans le document « F. Ossola, F. Maury ; MOCVD route to chromium carbonitride thin films using Cr(NEt2)4 as single-source precursor: growth and mechanism., Adv. Mater. Chem. Vap. Deposition, 3 (1997) 137-143*.* » (référence [6]).

Préférentiellement, lors du dépôt du feuillard interne par MOCVD ou DLI-MOCVD, l'additif liquide comprenant de l'azote est l'ammoniaque, ou éventuellement un précurseur moléculaire comprenant une liaison titane-azote. Une concentration élevée de l'additif liquide comprenant de l'azote favorise généralement la formation d'un nitrure au détriment d'un carbure dont le carbone provient des précurseurs organométalliques.

La température de dépôt par MOCVD ou DLI-MOCVD peut être comprise entre 300 °C et 400 °C afin de favoriser au mieux la proportion de la structure amorphe dans la matière composant le feuillard interne et donc la performance du feuillard interne en tant que barrière de diffusion.

Alternativement, la température de dépôt par MOCVD ou DLI-MOCVD peut être comprise entre 400 °C et 550 °C, afin d'augmenter la vitesse de dépôt.

Préférentiellement, la matière composant le feuillard interne comprend un nitrure de titane, un carbonitrure de titane, un nitrure mixte titane silicium, un carbure mixte titane silicium, un carbonitrure mixte titane silicium, un nitrure mixte titane aluminium ou leurs mélanges.

Le feuillard interne a généralement une épaisseur de 1 µm à 10 µm.

D'autres méthodes de dépôt peuvent également convenir pour déposer le feuillard interne, tel que par exemple un dépôt CVD, plasma CVD ou DLICVD, comme illustré respectivement par les documents « Jin Zhang, Qi Xue and Songxia Li, Microstructure and corrosion behavior of TiC/Ti (CN)/TiN multilayer CVD coatings on high strength steels. Applied Surface Science, 2013. 280: p. 626-631 *»* (référence [7]), « A. Weber, C. -P. Klages, M. E. Gross, R. M. Charatan and W. L. Brown, Formation Mechanism of TiN by Reaction of Tetrakis(dimethylamido)-Titanium with Plasma-Activated Nitrogen. Journal of The Electrochemical Society, 1995. 142(6): p. L79-L82*.* » (référence [8]) ou « Y. S. Li, S. Shimada, H. Kiyono and A. Hirose, Synthesis of Ti-Al-Si-N nanocomposite films using liquid injection PECVD from alkoxide precursors. Acta Materialia, 2006. 54 (8): p. 2041-2048 » (référence [9]).

Afin de déposer au moins une couche protectrice sur le support ou le substrat, le procédé de fabrication de l'invention comprend deux étapes selon son mode de réalisation général :
- une étape a) de vaporisation de la solution mère comprenant le ou les précurseurs de la couche protectrice,
- une étape b) de dépôt de la solution mère vaporisée au cours de laquelle la couche protectrice se forme sur le substrat.

L'étape a) de vaporisation de la solution mère est préférentiellement réalisée à une température de vaporisation comprise entre 120 °C et 220 °C.

La solution mère contient un solvant, un précurseur de type bis (arène) comprenant du chrome ; le cas échéant un précurseur additionnel et un inhibiteur d'incorporation de carbone.

Le choix du solvant contenu dans la solution mère répond généralement à plusieurs critères.

Tout d'abord, le point d'ébullition du solvant est inférieur à la température de l'évaporateur pour avoir une évaporation flash dans l'évaporateur. Il ne contient pas d'oxygène pour éviter l'oxydation des dépôts par craquage. Il est inerte chimiquement vis-à-vis du précurseur en solution et liquide dans les conditions standards de pression et de température, à savoir selon la présente description, la pression atmosphérique et une température de 25 °C. Enfin, le solvant ne se décompose pas significativement dans le réacteur, afin d'être récupéré dans l'effluent en sortie du réacteur et pour éviter ou limiter toute pollution.

Pour ces raisons notamment, le solvant de la solution mère est un solvant hydrocarboné, à savoir qu'il est composé uniquement de carbone et d'hydrogène.

De préférence, le solvant appartient à une famille chimique proche de celle des ligands d'au moins un composé précurseur, par exemple le précurseur de type bis (arène) comprenant du chrome appartenant à la famille des hydrocarbures aromatiques (ou arènes). En effet, durant le passage dans le réacteur, ce précurseur se décompose thermiquement, libérant ses ligands les uns après les autres. Les sous-produits de la réaction sont donc essentiellement des arènes libres, qui vont se mélanger au solvant d'autant mieux qu'ils seront chimiquement proches, voire identiques. De ce fait, les composés collectés dans l'effluent en sortie de réacteur (précurseur ou réactif non consommés, sous-produits de la réaction de DLI-MOCVD et solvant) sont généralement des hydrocarbures aromatiques.

Préférentiellement, le solvant est donc un hydrocarbure aromatique monocyclique, liquide dans les conditions standards, avec une température d'ébullition inférieure à 150 °C et une température de décomposition supérieure à 600 °C. Encore plus préférentiellement, il est choisi parmi le benzène, ou un benzène substitué par un ou plusieurs groupes, identiques ou différents, choisis indépendamment parmi un groupe méthyl, éthyl, ou isopropyl. Encore plus préférentiellement, le solvant est le toluène, le mésitylène (1,3, 5 -triméthylbenzène) ou l'éthylbenzène. Il est possible également d'utiliser comme solvant un mélange de ces composés.

Un des constituants principaux de la solution mère est un précurseur de type bis (arène) comprenant du chrome, et le cas échéant un précurseur additionnel.

Selon la composition choisie pour la solution mère, différentes matières protectrices décrites ci-après peuvent être déposées par décomposition des précurseurs au cours de l'étape b) de dépôt. Puisque toutes les matières protectrices contiennent du chrome, la solution mère contient au minimum le solvant et le précurseur de type bis (arène) comprenant du chrome, dont la concentration peut être choisie dans une large gamme. Cette concentration influe principalement sur la vitesse de dépôt selon l'étape b) : plus la solution mère est concentrée en précurseur, plus la vitesse de croissance du revêtement est importante.

La concentration du précurseur de type bis (arène) comprenant du chrome dans la solution mère peut être comprise entre 0,1 mol.L⁻¹ et 4,4 mol.L⁻¹ (concentration du précurseur pur), généralement entre 0,1 mol.L⁻¹ à 1 mol.L⁻¹, typiquement 0,35 mol.L⁻¹.

Outre les précurseurs de la couche protectrice et le solvant, la solution mère peut également comprendre un inhibiteur d'incorporation de carbone qui évite ou limite le dépôt d'une matière protectrice comprenant du carbone : une telle matière peut être un carbure, un carbure mixte, un carbonitrure ou un carbonitrure mixte, ces matières pouvant par exemple comprendre, en pourcentage atomique, 35 % de carbone et éventuellement 2 % à 3 % d'oxygène souvent localisé en surface de la couche protectrice.

Une faible quantité de carbone peut parfois être déposée avec le chrome au cours de l'étape b), sans pour autant former un carbure, même en présence de l'inhibiteur.

L'inhibiteur est un composé nucléophile, généralement un additif chloré ou soufré, dépourvu d'atome d'oxygène. Sa température de décomposition est supérieure à 500 °C, ce qui empêche ou limite la décomposition hétérogène des ligands aromatiques du précurseur de type bis (arène) comprenant du chrome au cours de laquelle, par dissociation des liaisons métal-ligand du précurseur, une partie des ligands hydrocarbures se décompose sous l'effet catalytique du substrat et apportent leurs carbones afin de former des céramiques de type carbure.

Préférentiellement, l'inhibiteur est un hydrocarbure aromatique monocyclique substitué par un groupe thiol ou au moins un chlore, encore plus préférentiellement l'inhibiteur est le thiophénol (C₆H₅SH) ou l'hexachlorobenzène (C₆Cl₆).

L'inhibiteur peut être présent à une concentration égale à 1 % à 10 % de la concentration molaire du précurseur de chrome dans la solution mère, par exemple 2 %.

Une fois la vaporisation de la solution mère réalisée à l'étape a), l'étape b) de dépôt peut être réalisée dans un réacteur à parois chaudes, classiquement utilisé dans ce domaine et opérant sous pression réduite. Le réacteur dans son ensemble est chauffé à la température requise pour le dépôt, de sorte que les parois, la phase gazeuse réactive circulant dans le réacteur et le substrat à recouvrir sont à la même température. Ce type de réacteur est aussi appelé "isotherme" (ou "quasi isotherme", car quelques gradients de température peuvent éventuellement subsister).

Un réacteur à parois froides peut aussi être utilisé, dans lequel seul le réacteur n'est pas à la température de dépôt mais à une température inférieure. Dans ce cas, le rendement du réacteur, déterminé à partir de la consommation en précurseur, est plus faible.

Selon l'invention, le réacteur de dépôt chimique en phase vapeur est à une température de dépôt comprise entre 300 °C et 600 °C, afin que tout précurseur de type bis (arène) présent dans la solution mère se décompose sans pour autant que le solvant ne se dégrade. Ceci évite de générer des sous-produits susceptibles de polluer l'enceinte en se déposant sur les parois du réacteur voire sur le substrat.

La température de dépôt selon l'étape b) est préférentiellement comprise entre 350 °C à 550 ° C, encore plus préférentiellement entre 350 °C et 450 °C ; afin d'éviter ou de limiter encore plus les déformations ou transformations de phase éventuelles du substrat lorsque celui-ci est métallique.

Alternativement, la température de dépôt selon l'étape b) est comprise entre 300 °C et 400 °C, ce qui améliore la densité de la couche protectrice et favorise son caractère amorphe, et donc sa résistance vis-à-vis de l'oxydation, de l'hydruration et/ou de la migration au travers du composant nucléaire de matière non désirée telle qu'une matière fissile.

L'étape b) de dépôt est réalisée sur la dernière couche du support. Par exemple, pour un dépôt sur la surface externe du support, le dépôt de la couche protectrice est réalisé sur le substrat ou sur la dernière couche intercalaire selon que le support contient respectivement un substrat nu ou revêtu d'au moins une couche intercalaire.

Après l'étape b), le procédé de fabrication de l'invention peut comprendre l'étape suivante :
c) réaliser sur ladite au moins une couche protectrice au moins une étape choisie parmi une étape postérieure de traitement de nitruration ionique ou gazeuse, de siliciuration ionique ou gazeuse, de carbosiliciuration ionique ou gazeuse, de nitruration ionique ou gazeuse suivie d'une siliciuration ou carbosiliciuration ionique ou gazeuse.

Cette étape de post traitement améliore la tenue en température et les propriétés tribologiques de la couche protectrice, plus particulièrement sa résistance à la rayure.

Ces méthodes de post traitement sont connues de l'homme du métier, et décrites par exemple dans le document *«* S. Abisset, F. Maury, R. Feurer, M. Ducarroir, M. Nadal and M. Andrieux ; Gas and plasma nitriding pretreatment of steel substrates before CVD growth of hard refractory coatings ; Thin Solid Films, 315 (1998) 179-185 » (référence [10]).

Parce que le traitement ionique est un traitement assisté par plasma pour lequel la température minimum de dépôt peut être d'environ 400 °C, il est applicable uniquement sur la surface externe d'une couche protectrice.

La température minimum de dépôt pour une carbosiliciuration gazeuse et une siliciuration gazeuse est respectivement d'environ 900 °C et environ 800 °C.

En général, les méthodes de siliciuration et de carburation utilisent respectivement du silane ou un de ses homologues (SiₙH₂ₙ₊₂) et un hydrocarbure (par exemple CH₄, C₃H₈, C₂H₂ ou C₂H₄) et peuvent opérer, respectivement sans ou avec un plasma à une température minimum d'environ 800 °C ou 400 °C.

De manière générale, les étapes a), b) et/ou c) sont réalisées avec un gaz porteur afin d'injecter toute espèce chimique dans le réacteur de dépôt chimique en phase vapeur. Le gaz porteur comprend au moins un gaz rare, le plus souvent inerte chimiquement vis-à-vis des différentes espèces chimiques présentes dans le réacteur. Le gaz rare peut être choisi parmi le xénon ou le krypton, mais de préférence parmi l'azote, l'hélium, ou l'argon. Le gaz porteur est par exemple à une pression comprise entre 0,2 Pa et 2 Pa.

Une fois les différentes étapes du procédé de fabrication de l'invention réalisées, l'effluent gazeux en sortie du réacteur de dépôt chimique en phase vapeur comprend des molécules de précurseur, le solvant et le cas échéant l'inhibiteur qui n'ont pas été consommés ni pyrolysés. L'effluent peut aussi comprendre des ligands libres dissociés du précurseur, qui sont de la même famille aromatique que le solvant. Ils s'intègrent dans le solvant de base avec lequel ils sont miscibles et agissent eux-mêmes comme solvant. Un avantage majeur et inattendu est que la majorité de ces composés en sortie du réacteur à basse température sont des molécules aromatiques monocycliques, généralement de structure chimique voisine ou identique à celle des composés initiaux que sont le précurseur ou le solvant. Il est donc intéressant de les recueillir. Ils sont gazeux en sortie de réacteur du fait des conditions de température et de pression, mais liquides dans les conditions standards. Le mélange ainsi collecté formera une solution, dite solution fille, qui pourra être introduite dans le réservoir d'alimentation du réacteur en tant que nouvelle solution mère apte à être utilisée à l'étape a) du procédé de fabrication de l'invention. Le procédé de recyclage qui en résulte est décrit dans la demande de brevet FR 1562862 (référence [11]).

Le procédé de fabrication de la présente invention, de par ses caractéristiques, permet un tel recyclage et peut donc fonctionner en cycle fermé, ce qui a de nombreux avantages : réduction voire élimination du rejet de substances néfastes pour l'environnement, gain économique par utilisation optimale des précurseurs et, comme illustré ci-après, augmentation de la dureté du revêtement protecteur.

À l'issue du procédé de fabrication de l'invention, le support est revêtu d'au moins une couche protectrice. Ce revêtement protecteur permet notamment de lutter contre l'oxydation, l'hydruration, et/ou la migration de toute matière non désirée à l'intérieur ou à l'extérieur du composant nucléaire telle que par exemple toute matière fissile issue du combustible nucléaire.

Les matières protectrices pouvant être déposées par le procédé de fabrication de l'invention sont variées. Elles sont décrites ci-après.

Au-delà d'une température de dépôt de 500 °C, le carbure de chrome n'est plus amorphe mais polycristallin.

Selon un autre mode de réalisation de l'invention, la solution mère contient le précurseur de type bis (arène) comprenant du chrome, un précurseur additionnel choisi parmi un précurseur de type bis (arène) comprenant du vanadium, un précurseur de type bis (arène) comprenant du niobium, un précurseur comprenant de l'aluminium ou le mélange de ces précurseurs additionnels ; de telle sorte qu'une matière protectrice comprenant un alliage de chrome choisi parmi un alliage chrome/vanadium, un alliage chrome/niobium, un alliage chrome/vanadium/niobium ou un alliage chrome/aluminium est obtenue en présence de l'inhibiteur ou qu'une matière protectrice comprenant un carbure de l'alliage de chrome choisi parmi un carbure d'un alliage chrome/vanadium, un carbure d'un alliage chrome/niobium, un carbure d'un alliage chrome/vanadium/niobium ou un carbure d'un alliage chrome/aluminium est obtenue en absence de l'inhibiteur.

Le carbure de l'alliage de chrome résulte de l'incorporation de carbone dans un des alliages de chrome précités, en formant un carbure d'insertion : il s'agit donc d'un carbure de l'alliage chrome/vanadium, d'un carbure de l'alliage chrome/niobium, d'un carbure de l'alliage chrome/vanadium/niobium ou d'un carbure de l'alliage chrome/aluminium (de préférence le carbure mixte Cr₂AlC de type « phase MAX »), pouvant respectivement être notés CrVC, CrNbC, CrVNbC, CrAlC sans que cette notation se réfère à une quelconque stœchiométrie.

De préférence, les alliages de chrome ou leur carbure correspondant sont des alliages mixtes ou des carbures mixtes (à savoir qu'ils ne comprennent pas d'autre élément métallique à une teneur significative, par exemple une teneur supérieure à 0,5 % atomique) et/ou ils sont des alliages de base chrome ou leur carbure d'alliage de base chrome correspondant.

Ces alliages améliorent la ductilité de la couche protectrice du composant nucléaire. Les teneurs de chaque élément au sein de l'alliage ou de son carbure mixte sont choisies par l'homme du métier afin d'obtenir les propriétés mécaniques, dont la ductilité, qui sont voulues dans un environnement nucléaire. Par exemple, la teneur atomique en vanadium ou niobium dans ces alliages peut être comprise entre 10 % et 50 %. En général, les rapports molaires entre le précurseur de type bis (arène) comprenant du chrome, et le précurseur de type bis (arène) comprenant du vanadium ou le précurseur de type bis (arène) comprenant du niobium sont proches ou correspondent respectivement au rapport stœchiométrique dans l'alliage de chrome entre le chrome, et le vanadium ou le niobium.

Selon un autre mode de réalisation de l'invention, la solution mère contient le précurseur de type bis (arène) comprenant du chrome, un précurseur liquide comprenant de l'azote en tant que précurseur additionnel étant présent dans la solution mère ou un précurseur gazeux comprenant de l'azote étant présent dans le réacteur de dépôt chimique en phase vapeur ; de telle sorte que la matière protectrice comprenant un nitrure de chrome est obtenue en présence de l'inhibiteur ou que la matière protectrice comprenant un carbonitrure de chrome est obtenue en absence de l'inhibiteur.

Dans une gaine de combustible nucléaire, une matière protectrice comprenant un nitrure de chrome et/ou un carbonitrure de chrome peut en outre avoir l'avantage de lutter contre l'interaction entre la surface interne de la gaine (en particulier du substrat) et la pastille de combustible nucléaire, dite interaction pastille-gaine. Dans ce but, le dépôt de la couche protectrice peut être complété par une étape de passivation visant à oxyder partiellement la couche protectrice, en la mettant par exemple en présence d'oxygène ou d'eau.

Préférentiellement, la température de dépôt selon l'étape b) est comprise entre 300 °C et 400 °C, encore plus préférentiellement entre 300 °C et 500 °C, par exemple 480 °C, de telle sorte que le nitrure de chrome est amorphe.

Une fois que tout l'inhibiteur est consommé pour éviter l'incorporation de carbone lors du dépôt du nitrure de chrome, un carbonitrure de chrome peut être formé avec les précurseurs restants. Un mélange de nitrure et de carbonitrure est alors obtenu.

Préférentiellement, le nitrure de chrome ou le carbonitrure de chrome est CrN, Cr₂N ou Cr₂(C,N).

La nature du nitrure déposé peut dépendre du rapport R entre la pression partielle du précurseur comprenant de l'azote et celle du précurseur de type bis (arène) comprenant du chrome : pour une température donnée, la phase hexagonale du nitrure Cr₂N est obtenue préférentiellement pour les faibles valeurs de R et la phase cubique du nitrure CrN pour les valeurs les plus élevées. L'homme du métier pourra également faire varier la température de dépôt ou la pression de dépôt afin de favoriser l'obtention de CrN ou Cr₂N.

Selon un autre mode de réalisation de l'invention, la solution mère contient le précurseur de type bis (arène) comprenant du chrome, un précurseur comprenant du silicium en tant que précurseur additionnel ; de telle sorte, qu'à une température de dépôt comprise entre 450 °C et 500 °C, la matière protectrice comprenant un carbure mixte chrome silicium est obtenue.

Le cas échéant, la matière protectrice comprenant un carbure mixte chrome silicium peut rentrer dans la composition d'une couche d'interphase positionnée entre une couche de nature métallique et une couche de nature céramique (par exemple d'une matière composite telle que SiC/SiC) afin de favoriser l'adhésion entre ces deux couches de nature différente.

Préférentiellement, le carbure mixte chrome silicium est amorphe, ce qui peut par exemple être favorisé par un pourcentage atomique de silicium proche d'un dopage chimique (par exemple un pourcentage atomique compris entre 1 % et 3 %) qui retarde la cristallisation de la matière protectrice et préserve la microstructure du carbure de chrome amorphe.

Comme illustré ultérieurement, le carbure mixte chrome silicium amorphe a une bonne durabilité.

Préférentiellement, le carbure mixte chrome silicium amorphe a pour formule générale CrₓSi_{y}C_{z}, avec les coefficients stœchiométriques « x » compris entre 0,60 et 0,70, « y » compris entre 0,01 et 0,05, et « z » compris entre 0,25 et 0,35.

Le carbure mixte chrome silicium peut être de type « phase MAX ».

Les phases MAX sont ici des carbures ternaires définis par la formule Mₙ₊₁AXₙ, où M est le chrome, A est le silicium et X est le carbone. Cette classe de matériaux est caractérisée par une structure cristalline hexagonale contenant un empilement de couches nanométriques, et une faible proportion d'atomes non métalliques (25 %, 33 % et 37,5 % lorsque n vaut 1, 2 et 3 respectivement). Ces matériaux possèdent à la fois un caractère métallique et des propriétés proches de celles des céramiques.

Le carbure mixte chrome silicium de type « phase MAX » selon l'invention contient de préférence l'atome de silicium selon un pourcentage atomique compris entre 15 % et 30 %. Préférentiellement, il est choisi parmi un carbure mixte de formule Cr₂SiC, Cr₃SiC₂, Cr₅Si₃C₂ ou leurs mélanges, ces carbures comprenant en pourcentage atomique 25 % de silicium, 17 % de silicium, 30 % de silicium et 25 % d'aluminium.

Selon un autre mode de réalisation de l'invention, la solution mère contient le précurseur de type bis (arène) comprenant du chrome, un précurseur comprenant du silicium en tant que précurseur additionnel, un précurseur liquide comprenant de l'azote en tant que précurseur additionnel étant présent dans la solution mère ou un précurseur gazeux comprenant de l'azote étant présent dans le réacteur de dépôt chimique en phase vapeur ; de telle sorte, qu'à une température de dépôt comprise entre 450 °C et 550 °C, la matière protectrice comprenant un nitrure mixte chrome silicium est obtenue en présence de l'inhibiteur ou la matière protectrice comprenant un carbonitrure mixte chrome silicium est obtenue en absence de l'inhibiteur.

Préférentiellement, le carbonitrure mixte chrome silicium ou le nitrure mixte chrome silicium est amorphe, structure qui est en particulier favorisée par une température de dépôt modérée.

Le nitrure mixte chrome silicium peut avoir pour formule générale Cr_{x'}Si_{y'}N_{w'}, avec les coefficients stœchiométriques « x' » compris entre 0,23 et 0,57, « y' » compris entre 0,003 et 0,240, et « w' » compris entre 0,42 et 0,56.

Le carbonitrure mixte chrome silicium peut avoir pour formule générale Cr_{x"}Si_{y"}C_{z"}N_{w"}, avec les coefficients stœchiométriques « x" » compris entre 0,20 et 0,56, « y" » compris entre 0,005 et 0,220, « z" » compris entre 0,05 et 0,34, et « w" » compris entre 0,06 et 0,50.

Pour obtenir la matière protectrice comprenant un carbure mixte chrome silicium, un nitrure mixte chrome silicium ou un carbonitrure mixte chrome silicium, le pourcentage molaire du précurseur comprenant du silicium peut être de 10 % à 90 % dans la solution mère, préférentiellement de 10 % à 25 %, par exemple 15 %. Le pourcentage molaire se définit ici comme le rapport entre le nombre de moles du précurseur comprenant du silicium/(la somme du nombre de moles du précurseur comprenant du silicium et du précurseur de type bis (arène) comprenant du chrome). Le précurseur comprenant de l'azote, qu'il soit gazeux ou liquide, est généralement présent en quantité excédentaire dans le réacteur de dépôt chimique en phase vapeur. Sa concentration est par exemple 100 à 200 fois supérieure à celle du précurseur de type bis (arène) comprenant du chrome.

Selon un autre mode de réalisation de l'invention, la solution mère contient en outre, en tant que précurseurs additionnels, au moins un précurseur de type bis (arène) comprenant un élément d'addition choisi parmi l'yttrium, l'aluminium, le vanadium, le niobium, le molybdène, le tungstène, un précurseur comprenant de l'aluminium ou de l'yttrium en tant qu'éléments d'addition ou leurs mélanges ; de telle sorte que la matière protectrice est dopée avec l'élément d'addition.

Ce dopage peut concerner toute matière protectrice mentionnée dans la présente description. Lorsque la matière protectrice est dopée avec l'élément d'addition, elle préserve généralement la microstructure de la matière protectrice non dopée correspondante au sein de laquelle l'élément d'addition est le plus souvent sous forme d'élément d'insertion voire dans certains cas sous forme d'élément de substitution comme par exemple une substitution du chrome par le silicium.

Préférentiellement, la matière protectrice comprend l'élément d'addition à une teneur de 1 % à 10 % atomique. Cette teneur augmente avec la température de dépôt et le pourcentage molaire dans la solution mère du précurseur de type bis (arène) comprenant un élément d'addition qui est en général supérieur au pourcentage atomique de l'élément d'addition dans la matière protectrice.

Les précurseurs destinés à obtenir chaque matière protectrice précédemment décrite peuvent avoir une composition variable.

Préférentiellement, l'élément M choisi parmi le chrome, le vanadium, le niobium ou l'élément d'addition est présent respectivement dans le précurseur de type bis (arène) comprenant du chrome, le précurseur de type bis (arène) comprenant du vanadium, le précurseur de type bis (arène) comprenant du niobium ou le précurseur de type bis (arène) comprenant l'élément d'addition. Chacun de ces précurseurs de type bis (arène) comprend donc l'élément M correspondant. De préférence, l'élément M est au degré d'oxydation zéro (M₀) afin de disposer d'un précurseur de type bis (arène) comprenant l'élément M₀.

De même, l'élément M choisi parmi le chrome, le tantale, le molybdène, le tungstène, le niobium ou le vanadium présent dans le précurseur de type bis (arène) comprenant une matière intercalaire choisie parmi le chrome, le tantale, le molybdène, le tungstène, le niobium, le vanadium, est de préférence au degré d'oxydation zéro (M₀) afin de disposer d'un précurseur de type bis (arène) comprenant l'élément M₀.

Dans le composé organométallique précurseur de type bis (arène), l'élément M₀ est complexé « en sandwich » par les ligands organiques que sont les groupements arène substitués ou non. Puisque l'élément M₀ a le même degré d'oxydation que dans le revêtement protecteur que l'on dépose (les carbures, nitrures, carbonitrures mixtes ou non étant généralement des composés d'insertion, l'élément M₀ y préserve le degré d'oxydation zéro), les précurseurs de type bis (arène) se décomposent le plus souvent sans réaction complexe telle que par exemple une réaction d'oxydoréduction générant de nombreux sous-produits.

Préférentiellement, le précurseur de type bis (arène) comprenant l'élément M₀ est un précurseur de type bis (arène) dépourvu d'atome d'oxygène de formule générale (Ar) (Ar') M₀ selon laquelle Ar, Ar', identiques ou différents, représentent chacun indépendamment les uns des autres un groupe aromatique de type benzène ou benzène substitué par au moins un groupe alkyl.

La stabilité de la liaison métal-ligand augmentant sensiblement avec le nombre de substituants du noyau benzénique, il est avantageux de choisir un précurseur dans lequel Ar et Ar' représentent deux ligands aromatiques faiblement substitués. Préférentiellement, les groupes aromatiques Ar et Ar' représentent alors chacun un ligand benzène, ou un ligand benzène substitué par un à trois groupes identiques ou différents choisis parmi un groupe méthyl, éthyl ou isopropyl.

Le précurseur de type bis (arène) comprenant l'élément M₀ peut ainsi être choisi parmi au moins un composé de formule M₀(C₆H₆)₂), M₀(C₆H₅Et)₂, M₀(C₆H₅Me)₂ ou M₀(C₆H₅iPr)₂. Il se décompose alors à partir d'environ 300 ° C. S'il a une température de décomposition supérieure à 600 °C, il n'est généralement pas retenu afin d'éviter la décomposition du solvant et limiter la formation de sous-produits.

De préférence, le précurseur de type bis (arène) comprenant l'élément M₀ a pour formule M₀(C₆H₅Et)₂, car son état liquide dans les conditions de l'étape a) de vaporisation diminue significativement la quantité de solvant dans la solution mère et ainsi augmenter la vitesse de dépôt au cours de l'étape b).

À titre d'exemple, lorsque le métal est le chrome, le précurseur peut être un composé sandwich du chrome, tel que le bis (benzène) chrome (dit BBC, de formule Cr (C₆H₆)₂), le bis (éthyl-benzène) chrome (dit BEBC, de formule Cr (C₆H₅Et)₂) de préférence, le bis (méthylbenzène) chrome (de formule Cr (C₆H₅Me)₂), et le bis (cumène) chrome (de formule Cr (C₆H₅iPr)₂), ou leur mélange. Le précurseur de type bis (arène) comprenant l'élément M₀ peut aussi être un dérivé dissymétrique de formule (Ar) (Ar') Cr où Ar et Ar' sont différents ; ou un mélange de ces bis (arène) chrome qui peut être riche en l'un de ces composés. Seul le BBC est sous forme d'une poudre. Il peut être injecté sous la forme d'une solution, mais la concentration est alors rapidement limitée par sa faible solubilité dans les solvants hydrocarbonés. Les autres précurseurs cités sont liquides et peuvent être directement injectés sans solvant, mais cela ne permet pas de bien contrôler la microstructure des dépôts. Leur usage en solution est préféré, car cela permet une large variation de la concentration de ladite solution, un meilleur ajustement des conditions d'injection et en conséquence des propriétés physiques.

Avantageusement, la solution mère peut contenir des précurseurs différents, sans influencer négativement le procédé de fabrication de l'invention. En particulier, la nature exacte des ligands aromatiques du métal n'est pas critique, sous réserve que ces ligands appartiennent de préférence à la même famille chimique des composés aromatiques monocycliques faiblement substitués. Les sous-produits de la réaction de DLI-MOCVD qui sont dérivés des réactifs initiaux peuvent donc être réintroduits dans le réacteur de dépôt chimique en phase vapeur, même si les produits collectés en sortie de réacteur présentent des variations structurelles entre eux. La pureté de la solution mère initiale n'est pas non plus un point critique, ce qui rend possible l'utilisation des solutions commerciales qui peuvent par exemple contenir jusqu'à 10 % de composés dérivés. Un recyclage de ces composés dérivés dans le procédé lui-même étant possible, les solutions mères recyclées qui seront utilisées pour un dépôt ultérieur contiendront différents bis (arène) à titre de précurseurs. La solution mère peut donc contenir un mélange de plusieurs précurseurs de formules générales (Ar) (Ar') M₀ différentes. De telles propriétés améliorent les capacités d'industrialisation du procédé de fabrication de l'invention.

Concernant les précurseurs comprenant un atome d'azote, généralement, le précurseur liquide comprenant de l'azote est l'hydrazine et/ou le précurseur gazeux comprenant de l'azote est l'ammoniaque. De manière générale, et sauf indication contraire, la concentration dans le réacteur de dépôt chimique en phase vapeur de l'ammoniaque ou de l'hydrazine est respectivement de 1 à 10 fois ou 1 à 500 fois supérieure à la concentration du précurseur de type bis (arène) comprenant du chrome.

Le précurseur comprenant du silicium peut être quant à lui un composé organosilane qui comprend de préférence un groupement de type phénylsilane ou alkylsilane. Préférentiellement, le précurseur comprenant du silicium est alors choisi parmi le diphénylsilane (C₆H₅)₂SiH₂, le monophénylsilane (C₆H₅)SiH₃, le diéthylsilane (C₂H₅)₂SiH₂, le triéthylsilane (C₂H₅)₃SiH ou leurs mélanges.

Le précurseur comprenant de l'aluminium peut être un tri(alkyl)aluminium de formule AlR₃, dans laquelle R est par exemple choisi parmi CH₃, C₂H₅ ou C(CH₃)₃.

Le précurseur comprenant de l'yttrium peut être un complexe alkyl de l'yttrium, particulièrement dans lequel le groupement alkyl a un encombrement stérique important, plus particulièrement un tri(alkyl)yttrium de formule YR₃. Il peut ainsi s'agir du tris(cyclopentadienyl)yttrium (noté YCp₃) dans lequel R = C₅H₅.

Le précurseur comprenant de l'yttrium peut également être un complexe amido de l'yttrium, plus particulièrement un tri(amido)yttrium de formule générique YL₃. Il peut ainsi s'agir du tris[*N*,*N*-bis(trimethylsilyl)amide]yttrium.

Au vu de ce qui précède, la couche protectrice déposée sur le support, notamment sur le substrat non revêtu de couche intercalaire, présente donc une grande variété de compositions.

À titre d'exemple, le composant nucléaire peut comprendre :
- un substrat à base de zirconium et une couche protectrice comprenant du chrome partiellement métastable (noté Cr/Zr), ou ;
- un substrat à base de zirconium et une couche protectrice comprenant du carbure de chrome amorphe (noté CrC/Zr), ou ;
- un substrat à base de molybdène et une couche protectrice comprenant du carbure de chrome amorphe (noté CrC/Mo), ou ;
- un substrat à base de zirconium et une couche protectrice comprenant du carbure mixte chrome silicium CrₓSi_{y}C_{z} (noté CrₓSi_{y}C_{z}/Zr).

La composition peut également varier au sein même d'une couche protectrice. Ainsi, une couche protectrice peut avoir un gradient de composition : lorsque la matière protectrice est composée de plusieurs éléments chimiques, par exemple les éléments A et B pour une matière de formule AxBy, un gradient de composition consiste à faire varier le pourcentage atomique x ou y d'au moins un élément A ou B suivant l'épaisseur du revêtement. Cette variation peut être continue ou par palier.

En pratique, pour faire varier ce pourcentage atomique, deux solutions mères plus ou moins riches en élément A ou B peuvent être injectées simultanément selon un débit variable au cours de la croissance de la couche protectrice à l'aide de deux injecteurs.

Une couche protectrice avec gradient de composition est particulièrement avantageuse en tant que couche intercalaire, car elle accommode progressivement les propriétés mécaniques du revêtement protecteur pour être en meilleure cohérence avec les propriétés correspondantes des matières dont elle fait la jonction. La matière protectrice déposée selon un gradient de composition est par exemple l'alliage de chrome ou son carbure, par exemple un alliage chrome/vanadium.

Le revêtement protecteur comprenant au moins une couche protectrice peut également avoir une variété de structures, de caractéristiques physico-chimiques et/ou de géométries au sein d'une ou plusieurs couches.

Ainsi, la couche protectrice peut avoir une structure colonnaire ou équiaxe. De préférence, la structure est équiaxe lorsque la couche protectrice a une fonction de barrière de diffusion. La propriété de barrière de diffusion d'un revêtement protecteur est influencée par sa microstructure. Ainsi, le plus souvent, la performance anti-diffusion d'un élément chimique exogène est croissante dans l'ordre suivant : colonnaire < équiaxe < amorphe.

Dans la structure colonnaire, les grains de la matière protectrice sont allongés, car ils se développent selon une direction préférentielle, généralement après que la couche protectrice atteigne une épaisseur critique telle par exemple quelques dizaines à centaines de nanomètres. La structure colonnaire est également favorisée par une reprise de croissance par épitaxie, généralement à haute température et en faisant croitre l'empilement de façon très rapide.

En revanche, dans la structure équiaxe, les grains de la matière protectrice se développent également selon toutes leurs directions préférentielles de croissance.

La couche protectrice peut également avoir une densité particulière. Elle est par exemple comprise entre 90 % et 100 % (de préférence 95 % à 100 %) de la densité à l'état massif du chrome métallique stable de structure cristallographique cubique centré selon le groupe d'espace Im-3m.

Préférentiellement, ladite au moins une couche protectrice a une dureté comprise entre 15 GPa et 30 GPa, de préférence entre 20 GPa et 29 GPa. Généralement, plus elle est dense, plus une couche protectrice est performante en tant que barrière de diffusion, par exemple pour empêcher la diffusion d'oxygène, hydrogène ou de toute matière non désirée. La densité d'une couche protectrice est généralement plus élevée lorsqu'elle fait partie d'un revêtement multicouche, ou est formée selon une vitesse de dépôt réduite par exemple en opérant à température ou pression réduite.

La géométrie du revêtement protecteur comprenant les couches protectrices peut également être variable.

Chacune de ladite au moins une couche protectrice peut avoir une épaisseur de 1 µm à 50 µm, encore plus préférentiellement de 1 µm à 25 µm, voire de 1 µm à 15 µm.

Alternativement, ladite au moins une couche protectrice peut avoir une épaisseur de 10 µm à 50 µm : cette couche protectrice d'épaisseur minimale favorise la résistance à l'oxydation.

Préférentiellement, l'épaisseur cumulée desdites couches protectrices est de 2 µm à 50 µm. Le composant nucléaire peut comprendre de 1 à 50 couches protectrices.

Le revêtement protecteur peut également être monocouche ou multicouche. Plusieurs couches protectrices de composition identiques ou différentes peuvent respectivement former un revêtement protecteur multicouche homogène ou un revêtement protecteur multicouche hétérogène.

Préférentiellement, le revêtement protecteur multicouche homogène défavorise généralement l'obtention d'une structure colonnaire. Il peut comprendre des couches protectrices composées du chrome partiellement métastable (sa densité favorisant le rôle de barrière de diffusion du revêtement multicouche homogène) ou de l'alliage de chrome, par exemple avec une épaisseur d'environ 400 nm, voire de 100 nm à 400 nm.

Un matériau multicouche se distingue d'un matériau monocouche de composition chimique globale équivalente, notamment par la présence d'interface entre les couches. Cette interface est telle qu'elle correspond généralement à une perturbation de la microstructure à l'échelle atomique. Elle est par exemple identifiée à l'aide d'une technique de caractérisation fine telle que la Microscopie Electronique en Transmission (MET) à haute résolution, la spectroscopie EXAFS (« Extended X-Ray Absorption Fine Structure »), une microsonde de Castaing qui donne un profil de composition, voire a posteriori par la présence éventuelle d'oxyde(s) puisque la zone d'interface est un chemin préférentiel d'oxydation.

Un matériau multicouche est généralement obtenu par un procédé qui réalise un dépôt séquencé de chaque monocouche. Afin de déposer le revêtement protecteur multicouche homogène, le dépôt de chaque couche peut être séparé par un temps de pause, compris par exemple entre 1 minute à 10 minutes, afin de purger le réacteur de dépôt chimique en phase vapeur.

À titre d'exemple, lorsque le revêtement protecteur est de type multicouche hétérogène, il peut comprendre des couches protectrices composées :
- de chrome et de carbure de chrome amorphe (noté Cr/CrC), ou
- de chrome et de nitrure de chrome (noté Cr/CrN), ou
- de carbure de chrome amorphe et de nitrure de chrome (noté CrC/CrN), ou
- de chrome, de carbure de chrome amorphe et de nitrure de chrome (noté Cr/CrC/CrN), ou- de chrome et de carbure mixte chrome silicium (noté Cr/CrₓSi_{y}C_{z}), ou
- de carbure mixte chrome silicium et de carbure de chrome amorphe (noté CrₓSi_{y}C_{z}/CrC), ou
- de carbure mixte chrome silicium et de nitrure de chrome (noté CrₓSi_{y}C_{z}/CrN), ou
- de chrome et de nitrure mixte chrome silicium (noté Cr/CrSixNy), ou
- de nitrure mixte chrome silicium et de carbure de chrome amorphe (noté CrSixNy/CrC), ou
- de nitrure mixte chrome silicium et de nitrure de chrome (noté CrSixNy/CrN), ou
- de carbure mixte chrome silicium et de nitrure mixte chrome silicium (noté CrₓSi_{y}C_{z}/CrSiₓN_{y}).

Afin de fabriquer un revêtement protecteur comprenant plusieurs couches de composition différente, une possibilité est d'utiliser autant d'injecteurs que de couches de composition différente, chaque injecteur permettant d'introduire une solution mère de composition spécifique dans le réacteur de dépôt chimique en phase vapeur.

Lorsque le revêtement protecteur multicouche hétérogène comprend une couche protectrice de chrome, la dernière couche protectrice du revêtement est généralement une couche protectrice de nature céramique (carbure, nitrure, carbonitrure, mixtes ou non).

Le composant nucléaire est un composant du cœur du réacteur nucléaire, plus particulièrement une gaine de combustible nucléaire, une grille d'espacement, un tube guide, un combustible à plaque ou une barre d'absorbant. Préférentiellement, la gaine de combustible nucléaire se présente sous forme d'un tube ou d'une plaque. La plaque peut résulter plus particulièrement de l'assemblage de deux sous-unités.

L'invention concerne également un composant nucléaire obtenu ou susceptible d'être obtenu par le procédé de fabrication de l'invention.

L'invention concerne également un composant nucléaire tel que décrit dans la revendication 7.

Ces deux types de composant nucléaire, à savoir le composant nucléaire selon l'invention, ainsi que le composant nucléaire obtenu ou susceptible d'être obtenu par le procédé de fabrication de l'invention, peuvent se présenter selon une ou plusieurs des variantes décrites dans la présente description pour le procédé de fabrication de l'invention, notamment les variantes relatives à la structure, les caractéristiques physico-chimiques (telles que par exemple la densité), la géométrie et/ou à la composition du composant nucléaire.

Ces variantes concernent notamment mais pas exclusivement : le substrat, la couche intercalaire, le feuillard interne, la couche protectrice dont sa combinaison avec un substrat particulier, le revêtement protecteur ou le type de composant nucléaire tels qu'ils sont détaillés dans la présente description, notamment la description du procédé de fabrication de l'invention.

Dans ces deux types de composant nucléaire, la matière protectrice comprend un alliage de chrome, un carbure d'un alliage de chrome, un nitrure de chrome, un carbonitrure de chrome, un carbure mixte chrome silicium, un nitrure mixte chrome silicium, un carbonitrure mixte chrome silicium, ou leurs mélanges.

Par exemple, pour ces deux types de composant nucléaire, les modes de réalisation particuliers de l'invention, éventuellement pris en combinaison, peuvent être tels que :
- le substrat est composé de zirconium ou d'un alliage à base de zirconium.
- la couche intercalaire comprend au moins une matière intercalaire choisie parmi le chrome, le tantale, le molybdène, le tungstène, le niobium, le vanadium, leurs alliages, un nitrure de titane, un carbonitrure de titane, un nitrure mixte titane silicium, un carbure mixte titane silicium, un carbonitrure mixte titane silicium, un nitrure mixte titane aluminium ou leurs mélanges.
- l'épaisseur de la couche intercalaire est de 1 µm à 5 µm.
- le composant nucléaire comprend en outre un feuillard interne placé sur la surface interne du support.
- la au moins une couche protectrice est une couche protectrice externe qui revêt la surface externe du support et/ou, lorsque le composant nucléaire comprend un volume interne ouvert ou non, une couche protectrice interne qui revêt la surface interne du support revêtu ou non du feuillard interne.
- la matière composant le feuillard interne comprend un nitrure de titane, un carbonitrure de titane, un nitrure mixte titane silicium, un carbure mixte titane silicium, un carbonitrure mixte titane silicium, un nitrure mixte titane aluminium ou leurs mélanges.
- le feuillard interne a une épaisseur de 1 µm à 10 µm.
- l'alliage de chrome est choisi parmi un alliage chrome/vanadium, un alliage chrome/niobium, un alliage chrome/vanadium/niobium ou un alliage chrome/aluminium ou le carbure de l'alliage de chrome est choisi parmi un carbure d'un alliage chrome/vanadium, un carbure d'un alliage chrome/niobium, un carbure d'un alliage chrome/vanadium/niobium ou un carbure d'un alliage chrome/aluminium.
- le carbure mixte chrome silicium est amorphe.
- le carbure mixte chrome silicium est de type « phase MAX ».
- le carbonitrure mixte chrome silicium ou le nitrure mixte chrome silicium est amorphe.
- la matière protectrice est dopée avec un élément d'addition choisi parmi l'yttrium, l'aluminium, le vanadium, le niobium, le molybdène, le tungstène ou leurs mélanges.
- la matière protectrice comprend l'élément d'addition à une teneur de 1 % à 10 % atomique.
- le composant nucléaire comprend un substrat à base de zirconium et une couche protectrice comprenant du carbure mixte chrome silicium CrₓSi_{y}C_{z}.
- la au moins une couche protectrice présente un gradient de composition.
- la au moins une couche protectrice a une structure équiaxe.
- la au moins une couche protectrice a une densité comprise entre 90 % et 100 % de la densité, à l'état massif, du chrome métallique stable de structure cristallographique cubique centré selon le groupe d'espace Im-3m.
- la au moins une couche protectrice a une dureté comprise entre 15 GPa et 30 GPa.
- chacune de la au moins une couche protectrice a une épaisseur de 1 µm à 50 µm, voire de 10 µm à 50 µm.
- plusieurs couches protectrices de composition identiques ou différentes forment respectivement un revêtement protecteur multicouche homogène ou un revêtement protecteur multicouche hétérogène.
- le revêtement protecteur multicouche homogène comprend des couches protectrices composées de l'alliage de chrome.
- le revêtement protecteur multicouche hétérogène comprend des couches protectrices composées :
   - de chrome et de nitrure de chrome, ou
   - de carbure mixte chrome silicium et de chrome, ou
   - de carbure mixte chrome silicium et de nitrure de chrome, ou
   - de nitrure mixte chrome silicium et de chrome, ou
   - de nitrure mixte chrome silicium et de nitrure de chrome, ou
   - de carbure mixte chrome silicium et de nitrure mixte chrome silicium.
   - le composant nucléaire est une gaine de combustible nucléaire, une grille d'espacement, un tube guide, un combustible à plaque ou une barre d'absorbant.

L'invention concerne également l'utilisation de ces types de composant nucléaire pour lutter contre l'oxydation et/ou l'hydruration dans une atmosphère humide comprenant de l'eau, en particulier sous forme de vapeur d'eau.

L'invention concerne également l'utilisation de ces types de composant nucléaire, pour lutter contre l'hydruration dans une atmosphère hydrogénée comprenant de l'hydrogène, en particulier une atmosphère hydrogénée comprenant plus de 50 % molaire d'hydrogène et/ou en outre de l'eau, en particulier sous forme de vapeur d'eau (par exemple au minimum 25 % molaire d'eau, notamment 25 % à 50 %).

L'atmosphère humide peut comprendre de 25 % à 100 % molaire, préférentiellement de 50 % à 100 % molaire, encore plus préférentiellement de 75 % à 100 % molaire de vapeur d'eau.

L'atmosphère humide ou l'atmosphère hydrogénée peut en outre comprendre un gaz additionnel choisi parmi l'air, l'azote, le dioxyde de carbone ou leurs mélanges.

Préférentiellement, ces utilisations ont pour but de lutter contre l'oxydation et/ou l'hydruration :
- dans laquelle l'atmosphère humide ou hydrogénée est à une température comprise entre 25 °C et 1400 °C, voire entre 25 °C et 1600 °C, plus particulièrement une température comprise entre 200 °C et 1300 °C, encore plus particulièrement entre 1200 °C et 1300 °C, voire entre 1300 °C et 1600 °C ; ou préférentiellement entre 800 °C et 1200 °C ; et/ou
- jusqu'à au moins 5000 secondes, plus particulièrement entre 1000 secondes et 5000 secondes, en particulier lorsque la température est comprise entre 1200 °C et 1300 °C ; et/ou
- en présence d'une vitesse de montée en température qui est comprise entre 0,1 °C/secondes et 300 °C/secondes ; et/ou
- suite à une trempe à l'eau du composant nucléaire, en particulier dans laquelle la trempe se déroule à une température comprise entre 25 °C et 400 ° C.

### EXPOSE DETAILLE DE L'INVENTION

Dans la présente description de l'invention, un verbe tel que « comprendre », « incorporer », « inclure », « contenir », « composé de » et ses formes conjuguées sont des termes ouverts et n'excluent donc pas la présence d'élément(s) et/ou étape(s) additionnels s'ajoutant aux élément(s) et/ou étape(s) initiaux énoncés après ces termes. Toutefois, ces termes ouverts visent en outre un mode de réalisation particulier dans lequel seul(s) le(s) élément(s) et/ou étape(s) initiaux, à l'exclusion de tout autre, sont visés ; auquel cas le terme ouvert vise en outre le terme fermé « consister en », « constituer de » et ses formes conjuguées.

L'expression « et/ou » vise à relier des éléments en vue de désigner à la fois un seul de ces éléments, les deux éléments, voire leur mélange ou leur combinaison.

L'usage de l'article indéfini « un » ou « une » pour un élément ou une étape n'exclut pas, sauf mention contraire, la présence d'une pluralité d'éléments ou étapes.

Tout signe de référence entre parenthèses dans les revendications ne saurait être interprété comme limitatif de la portée de l'invention.

Par ailleurs, sauf indication contraire, les valeurs aux bornes sont incluses dans les gammes de paramètres indiquées et les températures indiquées sont considérées pour une mise en œuvre à pression atmosphérique.

Tout revêtement, couche ou feuillard déposé à l'aide du procédé de fabrication de l'invention peut revêtir une partie ou de préférence toute la surface sur laquelle il repose.

Toujours dans la présente description, tout alliage est en général un alliage de base. On entend désigner par « alliage de base » du métal entrant notamment dans la composition du substrat, de la matière protectrice ou de la matière intercalaire, tout alliage à base du métal dans lequel la teneur du métal est au minimum de 50 % en poids du métal de l'alliage, particulièrement plus de 90 %, voire plus de 95 %. Le métal de base est par exemple le zirconium, le titane, le chrome, le tantale, le molybdène, le tungstène, le niobium ou le vanadium.

Un alliage peut également contenir d'autres éléments chimiques (par exemple à une teneur supérieure à 0,5 % atomique), en particulier un deuxième élément métallique, et constitue alors un alliage mixte.

L'élément carbone en insertion et/ou l'élément azote en insertion dans un alliage forment respectivement un carbure de l'alliage, un nitrure de l'alliage ou un carbonitrure de l'alliage, qui peuvent aussi être mixtes en présence d'un deuxième élément métallique.

L'alliage est de préférence apte à être utilisé dans le domaine nucléaire et/ou sous irradiation.

D'autres objets, caractéristiques et avantages de l'invention vont maintenant être précisés dans la description qui suit de modes de réalisation particuliers du procédé de l'invention, donnés à titre illustratif et non limitatif, en référence aux figures annexées.

### BREVE DESCRIPTION DES FIGURES

La Figure 1 représente le pourcentage massique de différents éléments chimiques en fonction de la profondeur obtenue par Spectrométrie de Décharge Luminescente (SDL) d'une plaquette de Zircaloy-4 recouverte d'une couche de carbure de chrome amorphe par le procédé de fabrication de l'invention, après son exposition à l'air ambiant.
Les Figures 2A (vue globale) et 2B (agrandissement au niveau du substrat oxydé) représentent des clichés de Microscopie Electronique en Transmission (MET) illustrant une coupe transverse de la plaquette dont l'analyse SDL est représentée sur la Figure 1.
Les Figures 3A et 3B illustrent, respectivement après exposition sous air sec et sous air humide, la prise de masse en fonction de la température pour des plaquettes de Zircaloy-4 recouvertes d'épaisseurs différentes d'une couche protectrice de CrC amorphe et pour une plaquette de Zircaloy-4 nue.
Les Figures 3C et 3D illustrent, respectivement après exposition sous air sec et sous air humide, la prise de masse à 1200 °C en fonction du temps pour des plaquettes de Zircaloy-4 recouvertes d'épaisseurs différentes d'une couche protectrice de CrC amorphe et pour une plaquette de Zircaloy-4 nue.
Les Figures 4A et 4B illustrent, respectivement après exposition sous air sec et sous air humide, la prise de masse en fonction de la température pour des plaquettes de molybdène recouvertes d'épaisseurs différentes d'une couche protectrice de CrC amorphe et pour une plaquette de molybdène nue.
Les Figures 5A et 5B illustrent, respectivement après exposition sous air sec et sous air humide, la prise de masse en fonction de la température pour des plaquettes de Zircaloy-4 recouvertes d'épaisseurs différentes d'une couche protectrice de chrome partiellement métastable et pour une plaquette de Zircaloy-4 nue.
Les Figures 5C et 5D illustrent, respectivement après exposition sous air sec et sous air humide, la prise de masse à 1200 °C en fonction du temps pour des plaquettes de Zircaloy-4 recouvertes d'épaisseurs différentes d'une couche protectrice de chrome partiellement métastable et pour une plaquette de Zircaloy-4 nue.
Les Figures 6A et 6B illustrent, respectivement en fonction de la température et en fonction du temps à 1200 °C, la prise de masse pour une plaquette de Zircaloy-4 recouverte d'une couche protectrice de carbure mixte chrome silicium CrₓSi_{y}C_{z} amorphe et pour une plaquette de Zircaloy-4 nue, sous air sec et sous air humide.

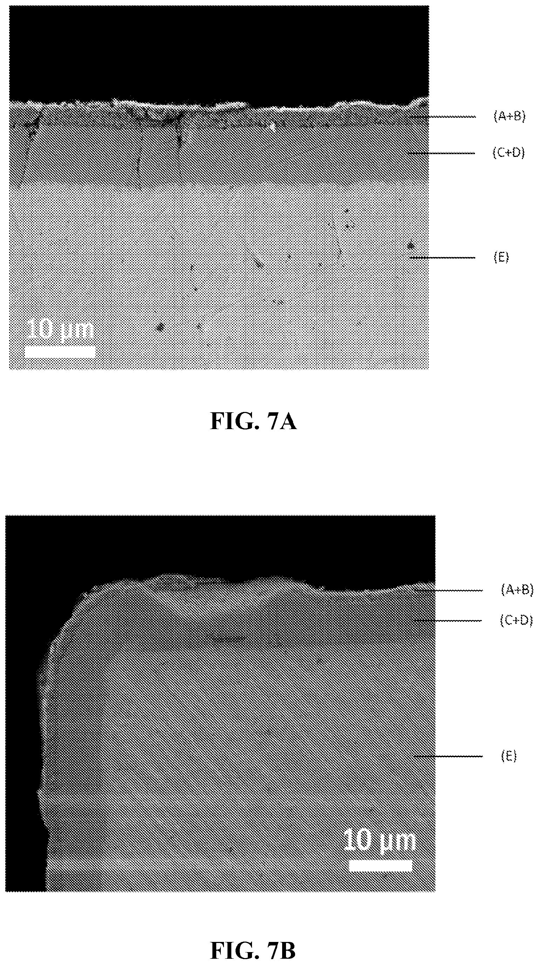

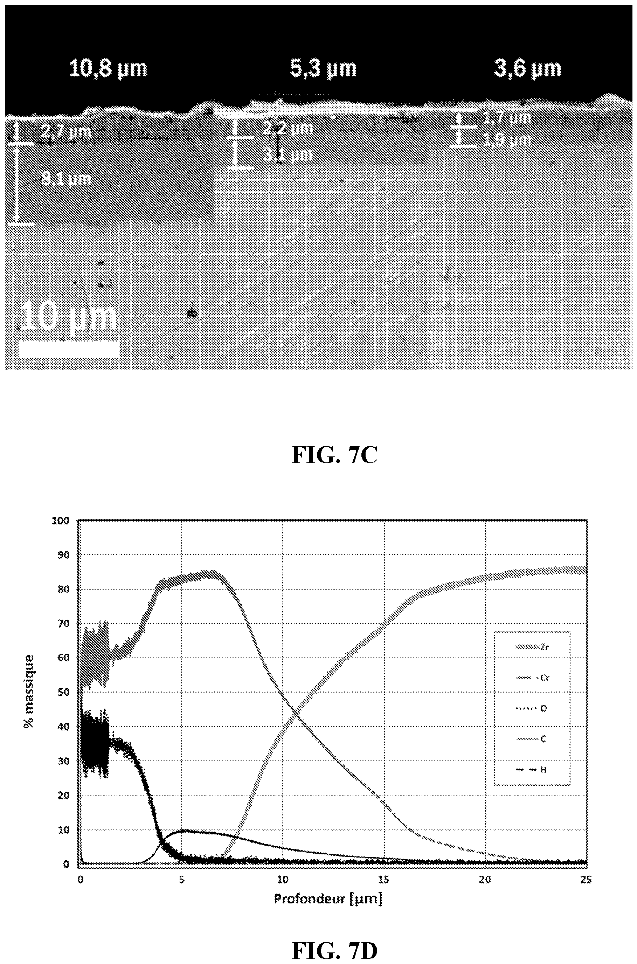

Les Figures 7A (vue d'un côté de la plaquette) et 7B (focus particulier sur un coin de la plaquette) représentent des clichés de Microscopie Electronique en Balayage (MEB) illustrant une coupe transverse d'une plaquette de Zircaloy-4 recouverte d'une couche protectrice de CrC amorphe déposé par le procédé de fabrication de l'invention soumise à une oxydation à 1100 °C suivie d'une trempe à l'eau. La Figure 7C est un cliché MEB correspondant à la Figure 7A dans laquelle des plaquettes recouvertes chacune d'une couche protectrice d'épaisseurs différentes sont regroupées (cliché de gauche : épaisseur de 9 µm, cliché central : épaisseur de 5 à 6 µm, cliché de droite : épaisseur de 2 à 3 µm). La Figure 7D illustre l'analyse SDL de la plaquette d'une épaisseur de 9 µm.
Les Figures 8A, 8B et 8C représentent des clichés MEB illustrant la microstructure d'un revêtement monocouche (8 A, 8B) ou multicouche (8 C) de chrome partiellement métastable déposé selon une vitesse croissante sur un substrat de silicium.
Les Figures 9A, 9B, 9C et 9D représentent des vues schématiques en coupe transversale de quelques-unes des géométries d'une gaine de combustible nucléaire de forme tubulaire obtenue par le procédé de fabrication de l'invention.

### EXPOSE DE MODES DE REALISATION PARTICULIERS

Les exemples de dépôt d'un revêtement sur substrat qui suivent sont réalisés dans un réacteur de dépôt chimique en phase vapeur placé dans un four tubulaire (modèle commercialisé par la société CARBOLITE). Le réacteur est composé d'un tube de silice : il est raccordé au système d'entrée et d'évacuation des effluents gazeux par des embouts étanches et à la solution mère par un injecteur (modèle Vapbox commercialisé par la société KEMSTREAM).

Dans les exemples qui suivent, le substrat n'est pas revêtu d'une couche intercalaire. Néanmoins, ces exemples sont transposables au cas où le substrat est constitué d'un substrat revêtu d'une couche intercalaire.

### 1. Revêtement sur un substrat de silicium.

À titre d'expérience préliminaire, le procédé de fabrication de l'invention est transposé à un substrat de silicium, une plaquette (« wafer ») de silicium carrée (1 cm de côté et 300 µm d'épaisseur) est placée dans le réacteur afin d'être recouverte d'une couche protectrice de carbure de chrome (CrC), chrome (Cr), ou carbure mixte chrome silicium (CrₓSi_{y}C_{z} noté CrSiC) en utilisant les composés suivants :
- précurseur de chrome : bis (éthyl-benzène) chrome dit BEBC (Cr (C₆H₅Et)₂),
- précurseur de silicium : bis (phényl) silane (H₂Si (C₆H₅)₂),
- inhibiteur : thiophénol (C₆H₅SH),
- solvant : toluène,
- gaz porteur : N₂ selon un débit de 500 sccm, à savoir 500 cm³/minutes sous des conditions standard,
- température de l'évaporateur : 200 ° C,
- durée du dépôt : 20 minutes.

Les autres conditions du dépôt de la couche protectrice constituant le revêtement externe sont indiquées dans le Tableau 1, en particulier le temps et la fréquence d'ouverture de l'injecteur, la température et la pression dans le réacteur de dépôt chimique en phase vapeur.

Les paramètres d'injection (fréquence et temps d'ouverture) agissent essentiellement sur la vitesse de dépôt et donc sur son épaisseur en variant la durée de dépôt. La fréquence d'ouverture est par exemple de 1 Hz à 10 Hz, couramment 10 Hz.

Les paramètres qui agissent sur les caractéristiques physico-chimiques et structurales du dépôt sont essentiellement la température de dépôt (agissant en particulier sur la structure : amorphe ou cristallisé ; dense ou poreux ; équiaxe ou colonnaire) et la composition de la solution injectée.

Par convention, le substrat de silicium recouvert du revêtement numéro N est appelé dans le Tableau 1 échantillon N : l'échantillon 1 désigne ainsi le substrat de silicium recouvert du revêtement 1.

**Tableau 1**

| **Revêtement (N)** | **Solution injectée** | **Conditions d'injection** | | **Pression totale de dépôt (10 ⁺³ Pa)** | **Température de dépôt (°C)** |
|---|---|---|---|---|---|
| | | Fréquence (Hz) | Temps d'ouverture (ms) | | |
| CrC (1) | BEBC (3,5. 10⁻¹ M) + toluène (50 ml) | 10 | 0,5-5 | 1,3 ; 6,7 | 450 ; 500 ; 550 |
| Cr (2) | BEBC (3,5. 10⁻¹ M) + thiophénol (2 % molaire) + toluène (50 ml) | 10 | 0,5-5 | 6,7 | 400 ; 450 |
| CrSiC (3) | BEBC (3,5. 10⁻¹ M) + bis (phényl) silane (15 % molaire) + toluène (50 ml) | 4 | 0,5 | 6,7 | 450 ; 500 |

Le Tableau 2 regroupe le résultat des analyses structurelles de ces revêtements, ainsi que le résultat des tests de tenue en température détaillés dans les exemples suivants (stabilité thermique : température à partir de laquelle une phase cristalline apparaît en DRX in situ sous argon). La composition atomique exprimée en pourcentage atomique est mesurée par microsonde de Castaing (dite « EPMA » en anglais pour « Electron Probe MicroAnalysis »). La variation des paramètres d'injection donne plusieurs épaisseurs de revêtement, se situant généralement entre 0,5 µm et 10 µm : les épaisseurs retenues pour les tests d'oxydation qui suivent sont indiquées dans le Tableau 2.

Concernant leur structure, le Tableau 2 montre que les revêtements CrC et CrSiC sont amorphes (aucune structure cristalline), le revêtement CrC étant néanmoins polycristallin pour une température de dépôt de 550 ° C. Quant à lui, le revêtement Cr comprend deux phases cristallines : une phase principale composée de cristaux de chrome cubique centré (bcc) selon le groupe d'espace Im-3m (paramètre de maille a = 2,88 Â) et une phase en proportion très minoritaire composée de cristaux de chrome de structure cristallographique cubique centré selon le groupe d'espace Pm-3n (paramètre de maille a = 4,59 Â) lorsque la température de dépôt par DLI-MOCVD est inférieure ou égale à 450 °C.

**Tableau 2**

| **Revêtement (N)** | **Epaisseur (µm)** | **Température de dépôt (°C)** | **Structure** | **Composition atomique** | **Stabilité thermique (°C)** |
|---|---|---|---|---|---|
| CrC (1) | 2 ; 5 ; 9 | 400 500 | Amorphe | Cr_{0,64}C_{0,33}O_{0,03} | Cr₇C₃ 580 Cr₃C₂ 590 Cr₂O₃ 610 |
| | | 550 | Polycristallin | Cr_{0,61}C_{0,32}O_{0,07} | |
| Cr (2) | 4 ; 6 | 400 450 | Polycristallin, bi-phasé : - phase principale Cr bcc (Im-3m) ; - phase métastable Cr bcc(Pm-3n). Structuré en multicouche pour augmenter la densité. | Cr_{0,69}C_{0,12}S_{0,08}O_{0, 11} | Cr phase métastable disparaît à 450 °C |
| CrSiC (3) | 4 | 450 500 | Amorphe | Cr_{0,66}Si_{0,02}C_{0, 29}O_{0, 03} | Cr₇C₃ 750 CrSi₂ 750 |

### 2. Évaluation de la tenue en température.

Les revêtements doivent résister à la température dans une atmosphère oxydante et jouer le rôle de barrière de diffusion.

Leur tenue à la température sous atmosphère inerte est d'abord étudiée par XRD in situ en fonction de la température sous Ar. La température à laquelle un changement structural apparaît (cristallisation, transformation de phase) est mesurée. De telles évolutions structurales sont susceptibles d'accélérer la diffusion d'oxygène au travers du revêtement vers le substrat, via les joints de grains ou microfissures. Le revêtement doit donc pouvoir garder son intégrité structurale aux températures les plus grandes possibles.

Les résultats de tenue en température obtenus pour les plaquettes revêtues dans l'exemple précédent sont regroupés dans le Tableau 2.

### 2.1. Tenue en température d'une plaquette Si/CrC amorphe sous atmosphère inerte.

Un substrat de silicium passivé par une couche de quelques centaines de nanomètres composée de nitrure de silicium amorphe (généralement Si₃N₄), disponible commercialement, est utilisé pour éviter toute diffusion avec la couche protectrice déposée à sa surface.

Alternativement, un substrat de silicium nu peut-être passivé par CVD thermique avec un mélange (SiH₄ + NH₃) ou par plasma (PECVD) avec NH₃.

Le substrat de silicium passivé est ensuite revêtu de carbure de chrome amorphe selon les conditions du Tableau 1 (conditions particulières : injection à 10 Hz, température de dépôt = 500 °C, pression de dépôt = 6700 Pa).

Dans une enceinte balayée par un flux d'argon pour limiter voire éviter toute contamination à l'oxygène, cet échantillon est chauffé de 30 °C à 800 °C selon une vitesse de montée en température de 5 °C/minutes tout en étant parallèlement analysé par diffraction de rayons X (DRX). Après refroidissement naturel jusqu'à 30 °C, un dernier spectre RX est enregistré.

L'analyse des spectres RX obtenus montre que l'échantillon garde une structure amorphe jusqu'à 570 °C. Il cristallise ensuite sous forme de Cr₇C₃ vers 580 °C, puis de Cr₃C₂ vers 590 °C, pour finalement s'oxyder en Cr₂O₃ vers 610 °C à cause des traces d'oxygène présentes à cause d'un défaut d'étanchéité à l'air du réacteur : ces trois phases vont subsister jusqu'à 800 °C avec une proportion de Cr₂O₃ qui augmente avec la température.

Ces résultats indiquent que le revêtement de carbure de chrome amorphe préserve son intégrité physique jusqu'à 800 °C sous atmosphère inerte d'argon.

### 2.2. Tenue en température d'une plaquette Si/Cr partiellement métastable sous atmosphère inerte.

Un substrat de silicium passivé comme précédemment est revêtu de chrome partiellement métastable selon les conditions du Tableau 1 (conditions particulières : température de dépôt = 400 °C, pression de dépôt = 6700 Pa).

Il est ensuite placé dans le réacteur balayé par un flux d'argon dans lequel il est progressivement chauffé de 30 °C à 600 °C selon une vitesse de montée en température de 1 °C/secondes. Il est parallèlement analysé par DRX (acquisitions de 35 minutes chacune à 30 °C et tous les 50 °C à partir de 350 °C).

L'analyse de ces spectres montre que le chrome partiellement métastable est polycristallin : il contient une phase stable (Im-3m) et une phase métastable (Pm-3n).

La phase métastable (Pm-3n) disparaît après 450 °C. En parallèle, la phase stable (Im-3m) reste présente tout au long du traitement thermique, les pics correspondants de DRX s'affinent et deviennent plus intenses grâce à l'amélioration de la cristallinité.

Au-delà de 550 °C, de l'oxyde de chrome Cr₂O₃ apparaît à cause des traces d'oxygène présentes dans la chambre d'analyse in situ.

À l'issue du cycle de température, l'échantillon se refroidit naturellement jusqu'à 30 °C : la phase métastable n'est plus présente, car elle a subi une transformation irréversible. Seule subsiste la phase stable, ainsi que des oxydes de chrome en faible proportion.

Ces résultats indiquent que le revêtement de chrome métallique a une tenue en température sous atmosphère inerte conforme au chrome conventionnel de structure cubique centré (bcc) stable dans les conditions normales.

Par ailleurs, il apparaît que la phase minoritaire de chrome métastable se transforme vers 450 °C pour former la phase principale stable de chrome : ceci est cohérent avec la littérature qui annonce la transformation du chrome métastable en chrome stable après 450 °C.

### 2.3. Tenue en température d'une plaquette Si/CrSiC et acier/CrSiC amorphe sous atmosphère inerte.

Un substrat de silicium passivé est revêtu d'un carbure mixte chrome silicium amorphe selon les conditions du Tableau 1 (condition particulière : rapport molaire de diphénylsilane sur BEBC = 15 %, température de dépôt 450 °C), puis est placé dans le réacteur balayé par un flux d'argon. Cet échantillon est chauffé de 30 °C à 750 °C selon une vitesse de montée en température de 1 °C/secondes tout en étant parallèlement analysé par DRX (acquisitions tous les 50 °C à partir de 400 °C).

De manière similaire à ces conditions opératoires, un substrat d'acier inoxydable 304L revêtu d'un carbure mixte chrome silicium amorphe à une température de dépôt 500 °C est également analysé par DRX (acquisitions tous les 50 °C à partir de 600 °C) lors d'un chauffage de 30 °C à 1100 °C.

L'analyse comparative des spectres DRX pour ces deux échantillons montre des comportements similaires : le caractère amorphe disparaît aux alentours de 750 °C par cristallisation d'un carbure de chrome Cr₇C₃ et du composé CrSi₂. De plus, elle montre que puisque CrSi₂ apparaît sur les deux substrats, ce composé se forme avec le silicium du revêtement et non pas celui du substrat, la couche de passivation de nitrure de silicium appliquée préalablement sur la surface du substrat silicium constituant une barrière de diffusion.

Au-delà de 750 °C, d'autres phases cristallines apparaissent : Cr₂O₃ après 850 °C et Cr₃C₂ après 1000° C. On note donc que l'ajout de Si dans le revêtement de carbure de chrome retarde sa cristallisation vers de plus hautes températures (750 °C au lieu de 580 °C).

### 3. Évaluation de l'oxydation sous air.

### 3.1. Résistance à l'oxydation sous air à 25 °C d'une plaquette Zr/CrC amorphe.

Afin d'évaluer sa résistance à une légère oxydation à température ambiante, une plaquette à base de l'alliage de zirconium Zircaloy-4 (dimensions : 45 mm X 14 mm X 1 mm) est revêtue d'une unique couche protectrice de carbure de chrome amorphe de 4 µm conformément aux conditions de dépôt indiquées au Tableau 1 pour le revêtement 1 (température de dépôt = 450 °C, pression de dépôt = 6700 Pa). Elle séjourne à l'air à température ambiante pendant quelques jours, ce qui aboutit à une très légère oxydation de surface du revêtement de carbure de chrome due au passage à l'air ambiant, comme pour la plupart des métaux et alliages.

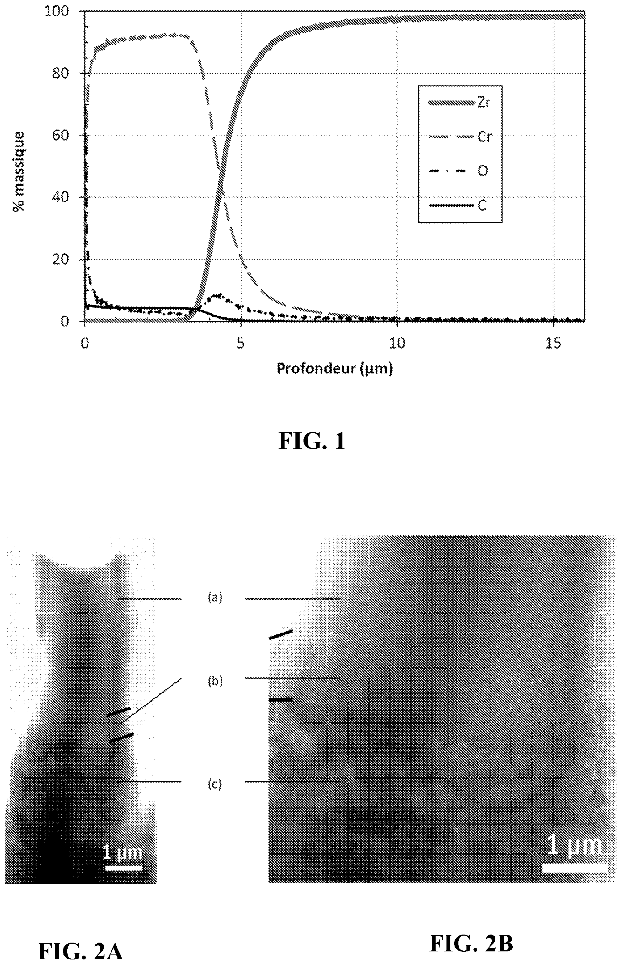

La composition élémentaire massique selon la profondeur dans cet échantillon est ensuite déterminée pour les éléments zirconium, chrome, oxygène et carbone par Spectrométrie de Décharge Luminescente (SDL). Elle est représentée sur la Figure 1 et révèle la présence d'un taux en oxygène non nul à l'interface entre le substrat et le revêtement.

Les valeurs moyennes de composition du revêtement trouvées avec cette technique concordent avec celles mesurées par microsonde (dite EPMA, acronyme anglais pour « Electron Probe Micro-Analyzer ») : en pourcentage pondéral en référence à la masse totale de la plaquette, 90 % de Cr, un peu moins de 10 % de C et quelques % de O, ce qui correspond en pourcentage atomique à une composition proche de Cr₇C₃.

Les clichés de Microscopie Électronique à Transmission (MET) représentés sur les Figures 2A et 2B sont réalisés à l'aide d'un microscope (JEM 2100 commercialisé par la société JEOL) muni d'un canon à émission de champ opérant à 200 kV : les zones délimitées sur ces clichés confirment ce résultat du profil de la Figure 1, notamment la présence d'une couche d'oxyde de zirconium ZrO₂ (zone b) d'épaisseur inférieure à 400 nm qui est située à l'interface entre le substrat non oxydé (zone a) et le revêtement (zone c).

Ces résultats sont confirmés par des analyses complémentaires par spectroscopie à dispersion d'énergie (EDS) qui indiquent une composition en pourcentage atomique d'environ 40 % de O et 60 % de Zr sur la zone interfaciale oxydée contre 5 % en O et 95 % de Zr sur la zone non oxydée du substrat.

La formation d'une couche de passivation à la surface du Zircaloy-4 est normale en absence de décapage surfacique spécifique. Cette couche peut éventuellement disparaître au cours des expériences d'oxydation et de montée en température.

Le substrat de zircaloy-4 était déjà oxydé superficiellement à la réception. Aucune autre source d'oxydation n'a pu être identifiée durant la phase de dépôt de la couche protectrice de carbure de chrome. L'échantillon ainsi revêtu n'a subi aucune oxydation supplémentaire à l'issue d'un stockage à l'air dans les conditions de température ambiante.

### 3.2. Résistance à l'oxydation sous air à 800 °C d'une plaquette de Si/CrC amorphe.

La plaquette de silicium recouverte de CrC amorphe fabriquée selon les conditions de l'exemple 2.1 est soumise à un vieillissement sous air à 800 °C pour des durées croissantes de 15, 30, 45, 60, 90, 120 et 180 minutes. Pour chaque température, l'échantillon est refroidi naturellement puis analysé par DRX à température ambiante.

L'analyse des spectres de DRX montre que sous air à 800 °C :
- après 15 minutes de traitement, les trois mêmes phases vues précédemment apparaissent : Cr₇C₃, Cr₃C₂ et Cr₂O₃. La phase amorphe semble disparue puisqu'aucune bosse large et étalée n'est visible vers 2 thêta = 30 ° ;
- après 90 minutes à 800 °C, il ne reste quasiment plus que du Cr₂O₃, comme si l'oxygène avait consommé tout le chrome appartenant aux carbures. Des pics résiduels caractéristiques de Cr₃C₂ sont encore présents, même après 180 minutes à 800 °C.

Ces résultats indiquent que le revêtement de carbure de chrome amorphe résiste à l'oxydation sous air à 800 °C pendant au moins 15 minutes. Au-delà de ces conditions, il commence à s'oxyder et cristalliser.

### 3.3. Résistance à l'oxydation en fonction de la température sous air sec ou humide de plaquettes de Zr ou Mo nues ou revêtues.

Afin d'étudier la résistance à l'oxydation sous air sec ou humide en fonction de la température, des analyses thermogravimétriques (dites ATG) sont réalisées sur des plaquettes pour ATG (dimensions : 6 mm X 4 mm X 1 mm, plaquettes percées d'un trou de 1 mm de diamètre pour être suspendues au fléau de la balance ATG) de Zircaloy-4 ou molybdène revêtues par le procédé de fabrication de l'invention de couches protectrices de différentes compositions (CrC amorphe, Cr partiellement métastable ou CrₓSi_{y}C_{z} amorphe) et différentes épaisseurs (9 µm, entre 5 µm et 6 µm, ou entre 2 µm et 3 µm).

Les conditions de dépôt sont celles du Tableau 1 pour les couches protectrices correspondantes qui recouvrent toutes les faces des plaquettes. Ces conditions sont complétées par les paramètres particuliers suivants :
- CrC amorphe : T = 450 °C et P = 6700 Pa ;
- Cr partiellement métastable : T = 400 °C ;
- CrxSizCy amorphe : T = 500 °C.

Ces analyses consistent à chauffer progressivement chaque échantillon de 25 °C à 1200 °C selon une vitesse de montée en température de 40 °C/minutes, puis à maintenir une température de 1200 °C.

Elles sont effectuées avec de l'air sec ou humide (27,5 % d'humidité relative).

La progression de l'oxydation de chaque échantillon est évaluée en mesurant sa prise de masse (due à la formation d'oxyde).

À titre comparatif, chaque analyse est répétée sur une plaquette sans couche protectrice.

### 3.3.1. Résultats pour une plaquette Zr/CrC amorphe.

Des plaquettes de Zircaloy-4 de différentes épaisseurs (2 µm, 5 µm, ou 9 µm) recouvertes chacune d'une couche protectrice de CrC amorphe sont soumises à une analyse par ATG sous air entre 25 °C et 1200 °C. À titre comparatif, une plaquette de Zircaloy-4 non revêtue est soumise à la même analyse.

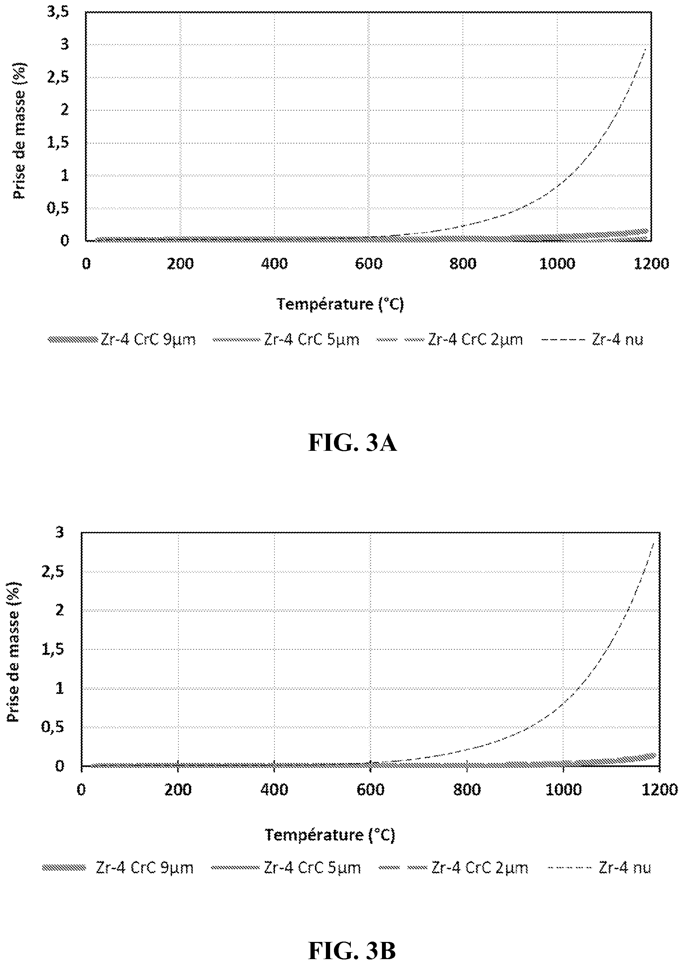

Comme illustré par les Figures 3A (air sec) et 3B (air humide), au cours de la montée en température de 25 °C à 1200 °C sur substrat de Zircaloy-4 revêtu de CrC amorphe, les prises de masses évoluent de manière équivalente sous air sec ou sous air humide, et ce quel que soit l'épaisseur de la couche protectrice.

Par contre, en comparaison, l'ampleur de l'oxydation est bien moins importante que celle du substrat nu : le substrat revêtu ne prend qu'environ 0,15 % en masse contre environ 3 % masse pour le substrat nu, soit 20 fois plus.

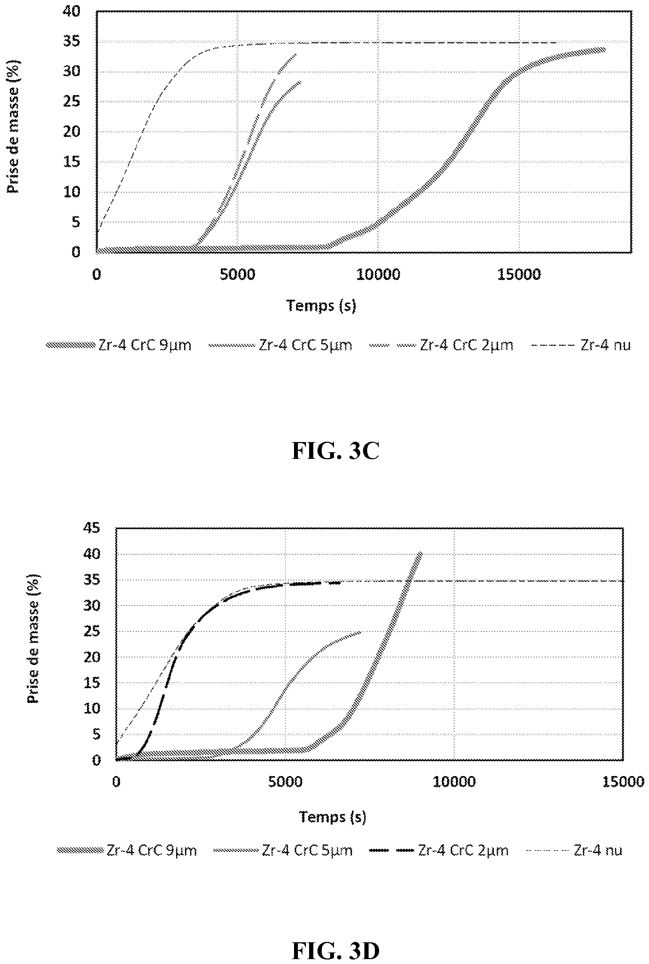

Au cours du palier de température à 1200 °C, les trois substrats de Zircaloy-4 revêtus de CrC amorphe s'oxydent progressivement au cours du temps. Ce ralentissement de l'oxydation catastrophique à partir de laquelle le substrat se désagrège est moins important pour l'atmosphère d'air humide qui est la plus oxydante (Figure 3D) par rapport à l'air sec (Figure 3C), mais augmente avantageusement avec l'épaisseur de la couche protectrice.

Des analyses DRX semblent indiquer que trois phases cristallines coexistent dans le revêtement : du Cr₂O₃ cristallisé, des oxydes de chrome amorphes et du carbure de chrome CrC amorphe.

En comparaison, le substrat nu s'oxyde immédiatement en ZrO₂.

La pénétration de l'oxygène est donc totale dans le substrat nu, alors qu'elle est bloquée ou fortement limitée jusqu'à 900 ° C. Au-delà de cette température, elle devient partielle et progressive dans les substrats revêtus, car le revêtement de CrC amorphe ralentit la cinétique d'oxydation.

Le revêtement de CrC amorphe protège et/ou retarde donc bien l'oxydation du substrat de Zircaloy-4 lors du chauffage de 25 °C à 1200 °C, même sous air humide. Cet effet bénéfique augmente avec l'épaisseur du revêtement.

### 3.3.2. Résultats pour une plaquette Mo/CrC amorphe.

Des plaquettes de molybdène de différentes épaisseurs (2 µm ou 5 µm) recouvertes chacune d'une couche protectrice de CrC amorphe sont soumises à une analyse par ATG sous air entre 25 °C et 1200 °C. À titre comparatif, une plaquette de molybdène non revêtue est soumise à la même analyse.

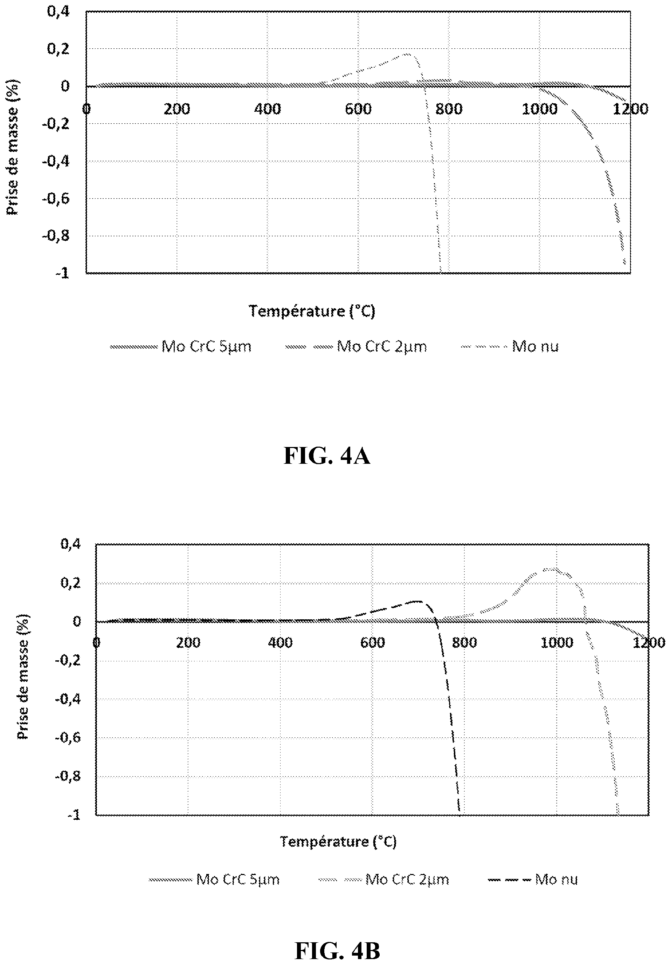

Comme illustré par les Figures 4A (air sec) et 4 B (air humide), au cours de la montée en température de 25 °C à 1200 °C sur substrat de molybdène revêtu de CrC amorphe, les prises de masses évoluent moins vite sous air sec que sous air humide qui est une atmosphère plus oxydante. Par ailleurs, plus le revêtement de CrC amorphe est épais, plus l'échantillon s'oxyde tardivement et est capable de résister à haute température : jusqu'à environ 1000 °C pour un revêtement de 2 µm, voire à plus de 1100 °C pour un revêtement de 5 µm.

La résistance à l'oxydation pour des épaisseurs supérieures du revêtement de CrC amorphe n'a pas pu être testée : elle devrait néanmoins évoluer favorablement.

En comparaison, le substrat nu de molybdène s'oxyde immédiatement sous air sec ou humide : au-delà de 600 °C, après une prise de masse due à la formation d'oxyde de molybdène, le substrat nu est ensuite totalement détruit par formation d'oxydes volatils, ce qui conduit à des pertes de masse rapides et négatives.

Puisque les différents échantillons sont rapidement détruits à une température de 1200 °C, l'analyse ATG isotherme correspondante n'est pas illustrée.

Le revêtement de CrC amorphe protège et/ou retarde donc bien l'oxydation du substrat de molybdène lors du chauffage de 25 °C à 1100 °C, même sous air humide. Cet effet bénéfique augmente avec l'épaisseur du revêtement.

### 3.3.3. Résultats pour une plaquette Zr/Cr partiellement métastable.

Des plaquettes de Zircaloy-4 sont recouvertes chacune de 9 couches protectrices de Cr partiellement métastable afin de former des revêtements multicouches de différentes épaisseurs (4 µm ou 6 µm).

L'empilement des 9 couches protectrices est réalisé en injectant la solution mère pendant 15 minutes puis en la stoppant pendant 5 minutes : un revêtement multicouche est ainsi obtenu en répétant 9 fois ce cycle dépôt/pause.

La reprise de l'injection après la pause de 5 minutes crée une interface qui peut être visualisée par une analyse MET du revêtement multicouche.

Cela évite la croissance colonnaire et densifie les revêtements.

Les plaquettes revêtues sont soumises à une analyse par ATG sous air entre 25 °C et 1200 °C. À titre comparatif, une plaquette de Zircaloy-4 non revêtue est soumise à la même analyse.

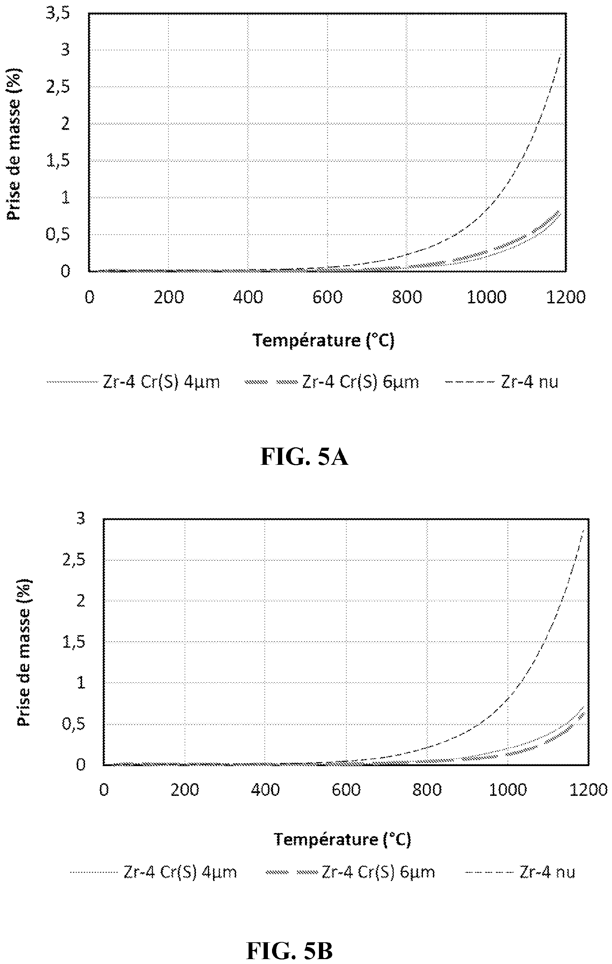

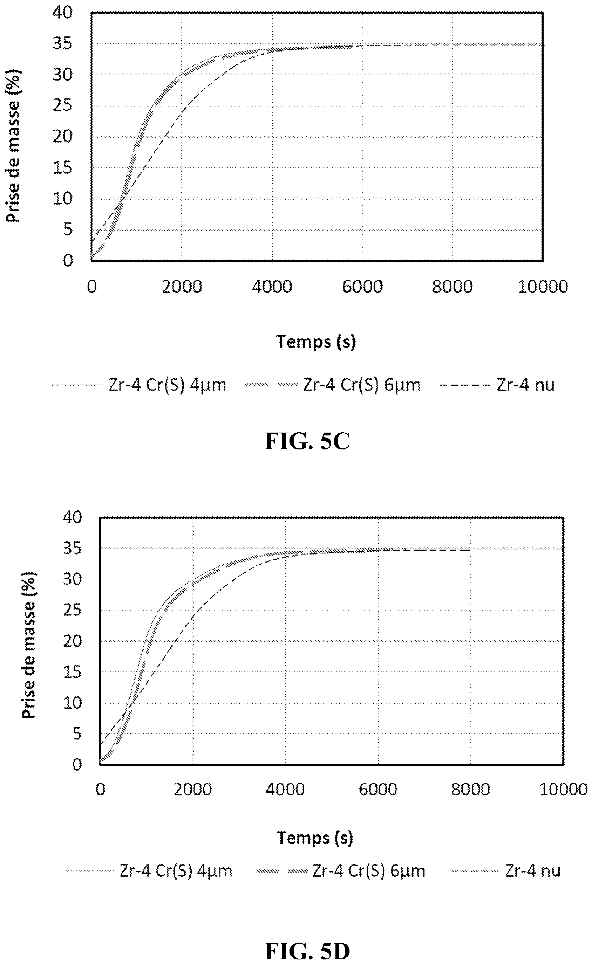

Comme illustré par les Figures 5A (air sec) et 5B (air humide), au cours de la montée en température de 25 °C à 1200 °C sur substrat de Zircaloy-4 revêtu de Cr partiellement métastable, les prises de masses évoluent de manière équivalente sous air sec ou sous air humide, quel que soit l'épaisseur de la couche protectrice.

Par contre, en comparaison, l'ampleur de l'oxydation est moins importante que celle du substrat nu : le substrat revêtu de Cr partiellement métastable ne prend qu'environ 0,8 % en masse contre environ 3 % masse pour le substrat nu (soit 3,75 fois plus), ce qui est toutefois moins protecteur que le revêtement de CrC amorphe précédemment analysé avec une prise de masse égale à 0,15 %.

Au cours du palier de température à 1200 °C, les deux substrats de Zircaloy-4 revêtus de Cr partiellement métastable s'oxydent progressivement au cours du temps comme illustré par les Figures 5C (air sec) et 5D (air humide). Par rapport à ce qui a été constaté avec la plaquette Zr/CrC amorphe (exemple 3.3.1), le revêtement multicouche de Cr partiellement métastable montre dans les premières secondes un retard à l'oxydation en comparaison avec le substrat nu, rapidement suivi par une accélération de cette oxydation.

Les origines de cette accélération défavorable à 1200 °C par rapport au substrat nu ne sont pas encore totalement élucidées. À ce stade, différentes hypothèses sont étudiées en vue d'optimiser l'effet protecteur du revêtement de Cr partiellement métastable vis-à-vis de l'oxydation.

Cependant, de manière avantageuse, même à 1200 °C, la plaquette Zr/Cr partiellement métastable montre une desquamation moins importante que la plaquette nue de Zr, ce qui garantit une meilleure tenue mécanique.

Des analyses DRX indiquent qu'à l'issue du palier de température à 1200 °C, tout le revêtement Cr partiellement métastable est oxydé en Cr₂O₃ et le substrat en ZrO₂.

Le revêtement de Cr partiellement métastable empêche ou limite fortement la pénétration de l'oxygène jusqu'à environ 900 °C, température au-delà de laquelle cette pénétration devient partielle et progressive.

Le revêtement de Cr partiellement métastable protège et/ou retarde donc bien l'oxydation du substrat de Zircaloy-4.

### 3.3.4. Résultats pour une plaquette Zr/CrₓSi_{y}C_{z}.

Une plaquette de Zircaloy-4 de 4 µm d'épaisseur recouverte d'une couche protectrice de carbure mixte chrome silicium CrₓSi_{y}C_{z} amorphe est soumise à une analyse par ATG sous air sec ou humide entre 25 °C et 1200 °C avec un palier de température à 1200 °C. À titre comparatif, une plaquette de Zircaloy-4 non revêtue est soumise à la même analyse, l'oxydation sous air sec ou humide donnant dans ce cas des résultats identiques.

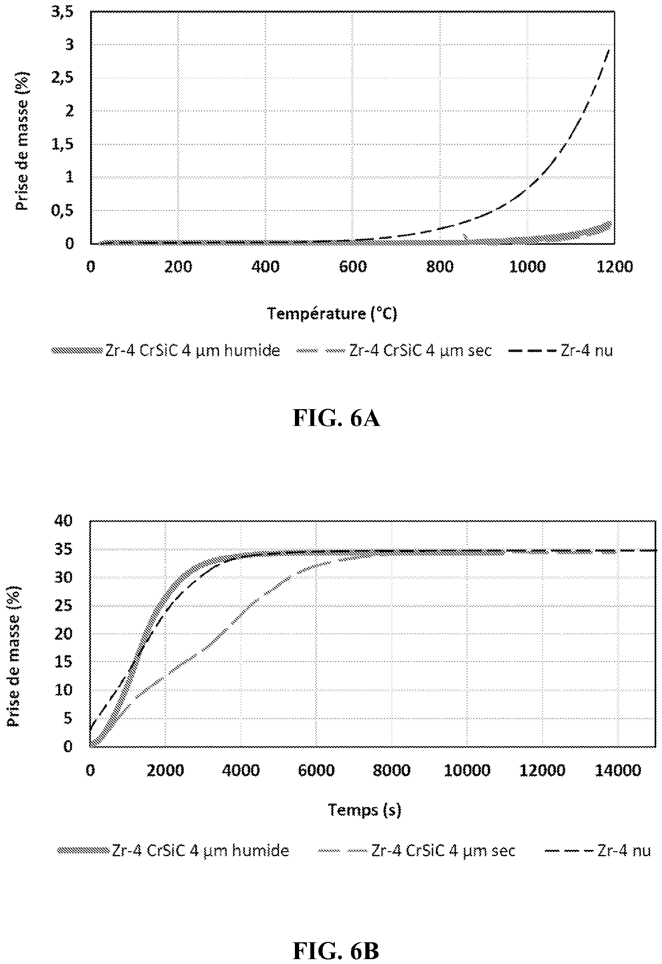

Comme illustré par la Figure 6A (25 °C à 1200 °C), la prise de masse évolue de manière proche sous air sec ou sous air humide pour le substrat de Zircaloy-4 revêtu de carbure mixte chrome silicium CrₓSi_{y}C_{z} amorphe : l'oxydation est retardée jusqu'à 700 °C sous air humide et 800 °C sous air sec. En comparaison avec le substrat nu, le substrat revêtu a une meilleure résistance à l'oxydation.

La Figure 6B (palier à 1200 °C) montre logiquement une meilleure résistance à l'oxydation sous air sec que sous air humide du substrat de Zircaloy-4 revêtu de carbure mixte chrome silicium CrₓSi_{y}C_{z} amorphe, sans pour autant améliorer cette propriété par rapport au substrat nu.

Cependant, de manière avantageuse, même à 1200 °C, la plaquette Zr/CrₓSi_{y}C_{z} montre une fissuration et un gonflement moins importants que la plaquette nue de Zr, ce qui garantit une meilleure tenue mécanique.

Des analyses DRX indiquent qu'à l'issue du palier de température à 1200 °C, tout le revêtement de carbure mixte chrome silicium CrₓSi_{y}C_{z} amorphe est oxydé (notamment en Cr₂O₃ pour le chrome) et le substrat en ZrO₂.

Le revêtement de carbure mixte chrome silicium CrₓSi_{y}C_{z} amorphe protège et/ou retarde donc bien l'oxydation du substrat de Zircaloy-4. Sa résistance à l'oxydation et sa tenue mécanique sont d'ampleurs intermédiaires à celles du CrC amorphe et du Cr partiellement métastable.

### 3.3.5. Évaluation de la résistance à l'oxydation et à l'hydruration après exposition d'une plaquette Zr/CrC à 1100 °C suivie d'une trempe à l'eau.

Des plaquettes de Zircaloy-4 (dimensions : 45 mm X 14 mm X 1 mm) de trois épaisseurs différentes (2 µm à 3 µm, 5 µm à 6 µm, ou 9 µm) recouvertes chacune d'une couche protectrice de CrC amorphe telle qu'utilisées dans l'exemple 3.3.1 sont oxydées sous air sec pendant 14 minutes, puis soumises à une trempe à l'eau de 10 secondes.

Les clichés en Microscopie Electronique à Balayage (MEB) d'une coupe de la plaquette de 9 µm résultant de ce traitement sont représentés sur les Figures 7A et 7B (zoom dans un coin de la plaquette) : bien que le substrat soit brut d'usinage, c'est-à-dire avec une certaine rugosité de surface, le revêtement est homogène en épaisseur et il recouvre parfaitement toutes les aspérités. La résistance mécanique des plaquettes est également préservée.

L'absence de dégradation du Zircaloy-4 à l'issue de ce test à 1100 °C avec trempe à l'eau est cohérente avec l'oxydation du Zircaloy-4 qui est croissante en fonction de la température et n'est significative qu'à partir de 1200 °C (exemple 3.3.1). La température plus basse (1100 °C) et la durée courte (14 minutes) font que l'oxydation est ici limitée au revêtement (voir Figures 7A et 7B) qui assure une bonne protection du Zircaloy-4.

En accord avec des profils SDL non représentés ici, trois couches principales de composition chimique différente peuvent être identifiées sur les clichés MEB des Figures 7 A et 7B, soit en allant du milieu extérieur vers le substrat de Zircaloy-4 :
- une couche externe de revêtement oxydé d'environ 4 µm d'épaisseur comprenant une zone A de 2 µm d'oxydes de chrome de surface (Cr₂O₃) et une zone B de 2 µm de revêtement partiellement oxydé (Cr₃C₂ résultant de la recristallisation du CrC amorphe lors de la montée en température + Cr₂O₃);
- une couche intermédiaire comprenant une zone C de revêtement non oxydé (CrC amorphe) en interface avec la couche externe et avec une zone D constituée de chrome et de carbone ayant diffusé dans le Zircaloy-4 avec lequel elle est en interface (avec formation éventuelle de carbure de zirconium ZrC cubique avec un paramètre de maille d'environ 4,7 Â, en particulier pour le revêtement le plus fin de 2 µm à 3 µm) ;
- une couche constituée du Zircaloy-4 (zone E).

Le revêtement de CrC amorphe protège donc le substrat de Zircaloy-4 vis-à-vis de l'oxydation pour les 3 plaquettes, puisqu'aucune formation de ZrO₂ n'est détectée. Seul le revêtement est partiellement oxydé en Cr₂O₃.

Le Tableau 3 regroupe les épaisseurs évaluées par SDL pour les zones A, B, C et D pour les trois plaquettes Zr/CrC, ainsi que les prises de masses globales correspondantes.

**Tableau 3**

| **Epaisseur initiale CrC (µm)** | **Zone A : Epaisseur Cr₂O₃ (µm)** | **Zone B : Epaisseur zone de transition CrCO (µm)** | **Zone C : Epaisseur CrC (µm)** | **Zone D : Epaisseur zone diffusion dans substrat (µm)** | **Prise de masse (mg. cm⁻²)** |
|---|---|---|---|---|---|
| 9 | 1,5 | 2,5 | 3 | 15 | 0,414 |
| 5-6 | 1,5 | 2,5 | 2 | 11 | 0,543 |
| 2-3 | 1,5 | 2,5 | 1 | 6 | 0,288 |

Le Tableau 3 est complété par la Figure 7C qui regroupe les clichés MEB d'une coupe transverse pour chacune des trois plaquettes, sachant que l'épaisseur totale du revêtement oxydé est supérieure à l'épaisseur du revêtement protecteur initial. Le cliché MEB de la plaquette d'épaisseur 5 µm à 6 µm montre une fissure résultant d'une décohésion accidentelle du revêtement initial.

Le Tableau 3 et la Figure 7C montrent que plus l'épaisseur du revêtement CrC initial est importante, plus le revêtement non oxydé (zone C) est épais et plus la zone de diffusion du revêtement non oxydé dans le substrat (zone D) l'est aussi._Par contre, l'épaisseur du revêtement oxydé (zone A) ne change pas : environ 2 µm de Cr₂O₃ et 2 µm de zone de transition partiellement oxydée (oxycarbure de chrome) (zone B). Le phénomène d'oxydation étant superficiel, et les conditions d'oxydation étant les mêmes, il est cohérent que l'épaisseur de Cr₂O₃ et de la zone de transition soient identiques dans la mesure où tout le revêtement CrC n'a pas été consommé. L'oxydation est partielle suivant l'épaisseur : moins de la moitié de l'épaisseur totale du revêtement est oxydée pour le revêtement le plus fin (2 µm à 3 µm) et un quart pour le plus épais (9 µm).

La prise de masse est la plus importante pour la plaquette avec une couche protectrice de 9 µm d'épaisseur, ce qui est également illustré par la Figure 7C qui montre une plus forte avancée de l'oxydation au sein du revêtement. Le rapport de la prise de masse entre les plaquettes avec revêtement de 9 µm et revêtement 2-3 µm est comparable au rapport des épaisseurs de revêtements oxydés : 1,44 contre 1,59.

Des analyses complémentaires montrent que les compositions élémentaires des revêtements sont comparables pour chaque plaquette en zones oxydée et non oxydée, avec les courbes qui atteignent les mêmes pourcentages massiques et suivent les mêmes tendances. En particulier, une diffusion de chrome et de carbone est observée dans le substrat Zircaloy-4, notamment sous la forme de ZrC, ce qui renforce avantageusement l'adhérence du revêtement au substrat.

Par ailleurs, la zone C de revêtement non oxydé (CrC amorphe) garde une microstructure très dense, constituée de petits grains de carbures de chrome cristallisés de taille submicronique.

Concernant la résistance à l'hydruration, l'analyse SDL de la plaquette d'une épaisseur de 9 µm illustrée par la Figure 7D montre un pourcentage massique d'hydrogène de 10 ppm non significatif dans le substrat de Zircaloy-4 après oxydation à 1100 °C suivie d'une trempe à l'eau, ce qui confirme la propriété de barrière de perméation à l'hydrogène du revêtement de carbure de chrome amorphe.

Même en conditions oxydantes à 1100 °C suivies d'une trempe, un composant nucléaire obtenu par le procédé de fabrication de l'invention peut garder une certaine intégrité mécanique et avoir une marge résiduelle confortable de résistance à l'oxydation/hydruration.

### 3.3.6. Conclusion.

De manière inattendue, les inventeurs ont découvert qu'un composant nucléaire obtenu par le procédé de fabrication de l'invention a une résistance à l'oxydation et/ou hydruration améliorée, en particulier à haute et très haute température, notamment en présence de vapeur d'eau.

De telles propriétés ne peuvent être anticipées au regard des spécificités chimiques et métallurgiques du zirconium et des alliages de zirconium utilisés pour les applications nucléaires, notamment au regard de leur composition chimique, état de surface, texture cristalline, état métallurgique final (écroui ou plus ou moins recristallisé), propriétés qui sont susceptibles d'influencer la qualité et le comportement des revêtements.

En particulier, la phase α d'un alliage de zirconium (notée « Zr-α », de structure cristallographique hexagonale compacte) à basse température se transforme en phase β (notée « Zr-β », de structure cristallographique cubique centrée) dans une gamme de température allant typiquement de 700 °C à 1000 °C. En passant de la structure Zr-α à la structure cubique Zr-β, l'alliage subit des variations dimensionnelles locales. Ces variations sont a priori défavorables à la tenue mécanique d'une couche externe qui recouvrirait une couche interne à base de zirconium, en raison notamment de l'incompatibilité de leurs coefficients de dilatation. Ces difficultés d'adhérence sont accentuées par les mécanismes de diffusion d'espèces chimiques qui sont plus rapides dans la phase Zr-β que dans la phase Zr-α, et qui peuvent modifier l'interface entre le substrat et son revêtement. Or, les différentes couches protectrices déposées avec le procédé de fabrication de l'invention ont montré une très bonne adhérence sur un substrat à base de zirconium, même dans des conditions extrêmes.

### 4. Microstructure d'un revêtement monocouche ou multicouche Si/Cr partiellement métastable.

Un substrat de silicium passivé est pourvu d'un revêtement monocouche de chrome partiellement métastable selon les conditions de l'exemple 2.2, ou d'un revêtement multicouche d'épaisseur et de composition chimique similaires en marquant en outre un temps de pause de 5 minutes entre le dépôt de chacune des 9 couches constituant le revêtement multicouche.

La microstructure de ces revêtements est illustrée par les clichés de MEB représentés par :

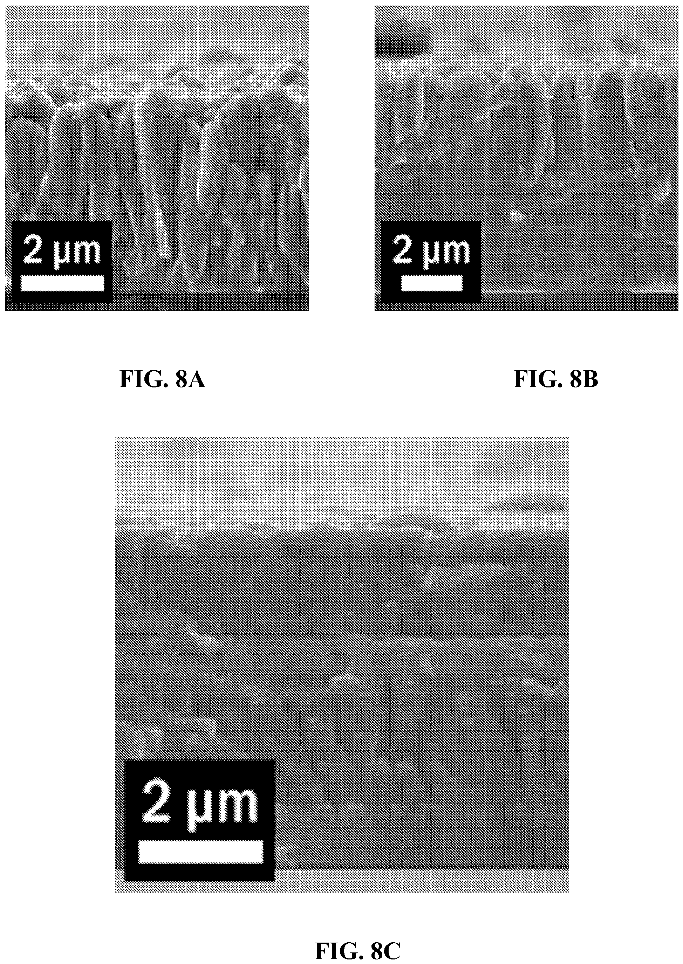

- Figure 8A : revêtement monocouche obtenu avec une vitesse de dépôt de 5 µm/heure ;
- Figure 8B : revêtement monocouche obtenu avec une vitesse de dépôt de 3 µm/heure ;
- Figure 8C : revêtement multicouche obtenu avec une vitesse de dépôt de 1 µm/heure.

Ces clichés montrent que les revêtements monocouches ont ici une microstructure colonnaire, alors que le revêtement multicouche a une microstructure équiaxe. La Figure 8C montre en particulier l'interface qui existe entre chacune des 9 couches qui sont visualisées individuellement au sein du revêtement multicouche.

Par ailleurs, la densité du revêtement augmente progressivement en diminuant la vitesse de dépôt du chrome partiellement métastable par réduction de la fréquence et du temps d'injection. La densité du revêtement multicouche est estimée à 7,7 ± 0,6 g.cm⁻³ par des analyses RBS (« Rutherford Backscattering Spectrometry ») : en tenant compte des incertitudes, elle est donc du même ordre de grandeur que la densité optimale de 7,2 g.cm⁻³ pour le chrome massif stable.

Les conditions de dépôt influent donc sur la microstructure du revêtement et sur sa densité. Généralement, la qualité d'un revêtement est inversement proportionnelle à sa vitesse de dépôt, comme le montre l'évolution d'une croissance colonnaire poreuse à une croissance équiaxe dense obtenue en diminuant la vitesse de dépôt. La diminution de la vitesse de dépôt peut être obtenue en diminuant la température de dépôt, en augmentant la pression de dépôt ou la concentration en précurseur de la solution mère injectée dans le réacteur de dépôt CVD.

### 5. Dureté des revêtements.

Afin de mesurer la dureté des revêtements précédemment obtenus ou obtenus dans des conditions similaires, des expériences de nano-indentation sont réalisées. Pour le revêtement de CrC amorphe, les mesures de dureté sont réalisées sur un revêtement obtenu à partir de précurseur neuf (3,5 µm d'épaisseur) ou de précurseur recyclé dans des conditions analogues à celles exposées dans l'exemple 6 (1 µm d'épaisseur).

La machine de nano-indentation est munie d'un indent de type Berkovich (pyramide à base triangulaire avec un angle de 65,27 ° entre la verticale et la hauteur d'une des faces de la pyramide). Les mesures sont faites dans le respect de la règle du dixième : enfoncement de l'indent de moins d'un dixième de l'épaisseur du revêtement. Un cycle de mesure se fait en trois temps :
- charge croissante jusqu'à la charge maximale, en 30 secondes ;
- maintien de la charge maximale pendant 30 secondes ;
- décharge pendant 30 secondes.

Les calculs effectués par le logiciel de mesure et d'analyse prennent en compte un coefficient de Poisson du revêtement de 0,2.

Les résultats sont regroupés dans le Tableau 4.

Les paramètres « H » et « E » sont la dureté et le module d'Young.

Les paramètres « H/E » et « H³/E² » évaluent la durabilité du revêtement :
- H/E : compare la résistance élastique à la rupture ou résistance à l'usure abrasive entre différents revêtements.
- H³/E² : caractérise le comportement élastique d'un matériau et est proportionnel à la résistance à la pénétration sous charge et à la déformation plastique.

**Tableau 4**

| **Revêtement** | **Epaisseur** (µm) | **Substrat** | ***H*** (GPa) | ***E*** (GPa) | ***H*/*E*** (-) | ***H³*/*E²*** (GPa) |
|---|---|---|---|---|---|---|
| CrₓC_{y} | 3,5 | Zircaloy-4 | 22,7 ± 2,3 | 266,5 ± 25,2 | 8,5*10^{- 2} | 1,6*10⁻¹ |
| CrₓC_{y} recyclé | 1,0 | Zircaloy-4 | 28,9 ± 6,4 | 315,0 ± 41,2 | 9,2*10^{- 2} | 3,6*10⁻¹ |
| Cr (S) colonnaire | 3,5 | Zircaloy-4 | 9,7 ± 0,8 | 344,8 ± 32, 0 | 2,8*10⁻² | 7,7*10⁻³ |
| Cr (S) dense | 5,5 | Zircaloy-4 | 16,9 ± 0,6 | 280,1 ± 72,7 | 6,0*10^{- 2} | 6,2*10⁻² |
| CrₓSi_{z}C_{y} | 5,5 | Zircaloy-4 | 19,9 ± 2,8 | 180,8 ± 17,6 | 1,1*10^{- 1} | 4 58*10⁻¹ |
| Cr massif | - | - | 6,1 ± 0,4 | 224,2 ± 21, 4 | 2,7*10^{- 2} | 4,5*10⁻³ |
| Zircaloy-4 massif | - | - | 4,4 ± 0,4 | 108,8 ± 15,7 | 4,0*10^{- 2} | 7,2*10⁻³ |

Pour les différents revêtements, ces résultats montrent que :
- Cr partiellement métastable : ce revêtement a une dureté élevée d'environ 17 GPa. Cette dureté est 2 fois supérieure à celle du chrome dur électrolytique disponible commercialement. Elle est dans la gamme haute du chrome métallique massif de dureté, généralement comprise entre 6 GPa et 25 GPa suivant le procédé d'élaboration.
- carbure de chrome amorphe CrC : ce revêtement a une dureté notablement élevée comprise entre 22 GPa et 29 GPa. Les meilleures duretés sont obtenues lorsque les précurseurs non consommés à l'issue du procédé de fabrication de l'invention sont recyclés.

En comparaison, la gamme de dureté d'un carbure de chrome de l'état de la technique varie généralement entre 5 GPa et 24 GPa selon le procédé utilisé et les conditions de dépôt.

La gamme élevée de dureté du revêtement de carbure de chrome amorphe obtenu par le procédé de fabrication de l'invention est inattendue : il est généralement admis qu'un carbure de chrome est bien moins dur sous forme amorphe que cristallisée, voire que la présence de carbone ramollirait un revêtement à base de chrome.
- CrSiC amorphe : en comparaison avec le revêtement de CrC amorphe, ce revêtement a une dureté d'environ 20 GPa qui est plus faible, mais avantageusement son module d'Young de 180 GPa est bien inférieur. Le revêtement de CrSiC amorphe a ainsi une durabilité très élevée (H/E = 11,1*10⁻² et surtout H³/E² = 4,6*10⁻¹ GPa), qui vient concurrencer des revêtements à forte durabilité spécialement conçus pour cet objectif.

### 6. Recyclage des précurseurs.

L'exemple de procédé de dépôt avec recyclage qui suit est extrait de la demande de brevet FR 1562862 (référence [11]). Il concerne le dépôt d'un revêtement de carbure de chrome amorphe sur un substrat de silicium et illustre par analogie la possibilité de recycler un ou plusieurs des précurseurs ou leurs dérivés qui restent à l'issue du procédé de fabrication de l'invention. Le recyclage est réalisé avec un piège cryogénique.

Le dépôt d'un revêtement de carbure de chrome CrC amorphe est réalisé dans les conditions suivantes :
Conditions d'injection :
   - temps d'ouverture de l'injecteur : 0,5 ms
   - fréquence : 10 Hz
Réactif : BEBC (5 g)
Solvant : Toluène (50 mL)
Gaz porteur : N₂ (débit de 500 sccm, à savoir 500 cm³/min sous des conditions standard)
Durée du dépôt : 20 minutes
Température de dépôt : 450 °C ; pression de dépôt : 6666 Pa
Température d'évaporation : 200 °C
Température du piège cryogénique : -120 °C
Quantité de solution fille récupérée : 30 mL

Deux expériences N1 et N2 sont réalisées avec une solution mère de BEBC. Dans une troisième expérience, les deux solutions filles obtenues à l'issue de N1 et N2 sont récupérées pour former une solution mère recyclée qui est utilisée en tant que source de précurseur pour une troisième opération de dépôt N3.

Pour N1 et N2, l'épaisseur du revêtement est typiquement de 5 µm. Un revêtement d'environ 1,5 µm est obtenu à l'issue de N3. La concentration en BEBC est déterminée et le rendement calculé pour N1 et N2 (voir Tableau 5).

**Tableau 5**

| **n° expérience** | **solution injectée (ml)** | **[BEBC] dans la solution injectée (g/ml)** | **solution fille récupérée (ml)** | **[BEBC] dans la solution fille (g/ml)** | **rendement par rapport au précurseur (%)** |
|---|---|---|---|---|---|
| N1 | 55 | 0,078 | 30 | 0,031 | 60 % |
| N2 | 50 | 0,083 | 30 | 0,034 | 59 % |
| N3 | 30 +30 | 0,040 | 35 | Pas mesurée, car très faible | N/A |

Des analyses complémentaires montrent que les compositions et microstructures amorphes des revêtements ne dépendent pas de la concentration en précurseur de la solution injectée. Par contre, une solution fille contenant un précurseur recyclé permet de déposer un revêtement d'une dureté supérieure à celui obtenu avec le précurseur initial de la solution mère.

### 7. Géométrie du composant nucléaire selon l'invention.

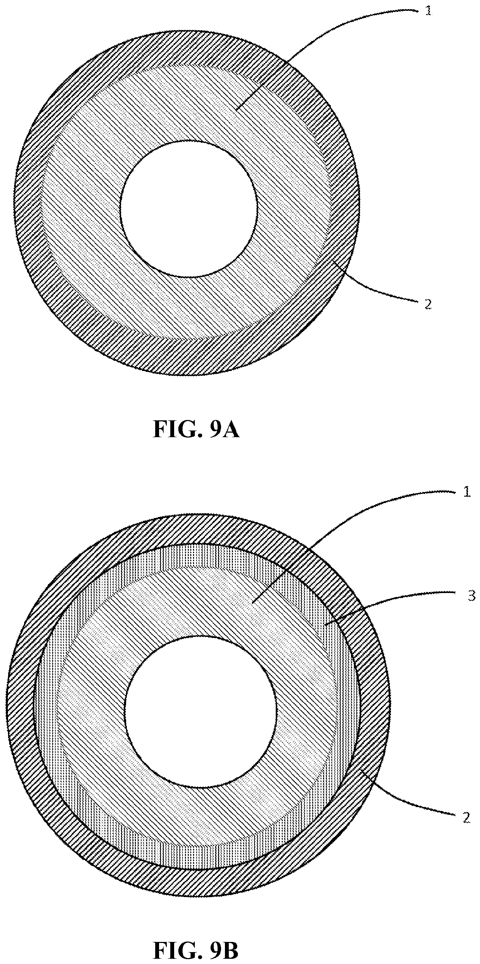

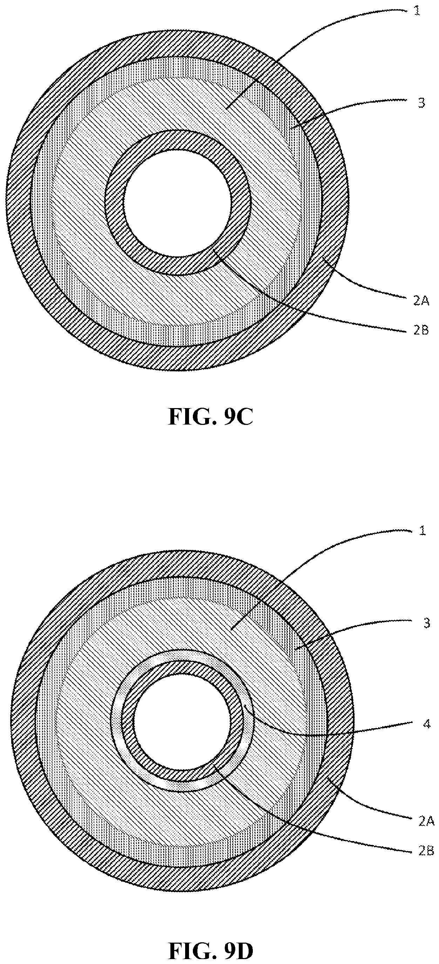

Le composant nucléaire obtenu par le procédé de fabrication de l'invention est décrit selon une coupe transversale en référence aux Figures 9A, 9B, 9C et 9D dans le cas particulier non limitatif d'une géométrie tubulaire.

Lorsque le composant nucléaire est massif ou ne délimite pas de volume interne accessible, il ne comprend généralement pas de revêtement déposé sur la surface interne du substrat.

Selon un premier mode de réalisation de l'invention, la gaine illustrée par la Figure 9A comprend un substrat 1 dont la surface interne délimite un volume apte à recevoir le combustible nucléaire. Le substrat 1 forme un support (non revêtu d'une couche intercalaire pour ce mode de réalisation) sur lequel est placée une couche protectrice 2 composée d'une matière protectrice qui améliore la résistance à l'oxydation de la gaine.

Selon un deuxième mode de réalisation illustré par la Figure 9B, la gaine est en outre pourvue d'une couche intercalaire 3 placée entre le substrat 1 et la couche protectrice 2. Dans ce cas, la combinaison du substrat 1 et de la couche intercalaire 3 forme le support. La couche intercalaire 3 est composée d'au moins une matière intercalaire apte à éviter ou limiter la diffusion de la matière protectrice de la couche protectrice 2 vers le substrat 1.

Selon un troisième mode de réalisation illustré par la Figure 9C, la gaine selon le deuxième mode de réalisation est en outre pourvue d'une couche protectrice interne 2B en contact avec le volume interne de la gaine et ici disposée sur la face interne du substrat 1 (non revêtue donc d'un feuillard interne pour ce mode de réalisation). La couche protectrice interne 2B complète la protection conférée par la couche protectrice externe 2A.

Selon un quatrième mode de réalisation illustré par la Figure 9D, la gaine selon le troisième mode de réalisation est en outre pourvue d'un feuillard interne 4 positionné entre la couche protectrice interne 2B et le substrat 1. Le feuillard interne 4 constitue une barrière de diffusion.

Bien entendu, selon les propriétés recherchées, d'autres modes de réalisation sont possibles en fonction de la présence ou non dans chaque mode de réalisation de la couche intercalaire 3, de la couche protectrice externe 2A, de la couche protectrice interne 2B et/ou du feuillard interne 4.

La présente invention n'est nullement limitée aux formes de réalisation décrites et représentées, et l'homme du métier saura les combiner et y apporter avec ses connaissances générales de nombreuses variantes et modifications.

### REFERENCES CITEES

[1] F. Maury, A. Douard, S. Delclos, D. Samelor, C. Tendero; Multilayer chromium based coatings grown by atmospheric pressure direct liquid injection CVD; Surface and Coatings Technology, 204 (2009) 983-987.
[2] A. Douard, F. Maury ; Nanocrystalline chromium-based coatings deposited by DLI-MOCVD under atmospheric pressure from Cr(CO)6 ; Surface and Coatings Technology, 200 (2006) 6267-6271.
[3] WO 2008009714
[4] WO 2008009715
[5] S. Anderbouhr, V. Ghetta, E. Blanquet, C. Chabrol, F. Schuster, C. Bernard, R. Madar ; LPCVD and PACVD (Ti,Al)N films: morphology and mechanical properties ; Surface and Coatings Technology, Volume 115, Issues 2-3, 18 July 1999, Pages 103-110.
[6] F. Ossola, F. Maury ; MOCVD route to chromium carbonitride thin films using Cr(NEt2)4 as single-source precursor: growth and mechanism., Adv. Mater. Chem. Vap. Déposition, 3 (1997) 137-143.
[7] Jin Zhang, Qi Xue and Songxia Li, Microstructure and corrosion behavior of TiC/Ti(CN)/TiN multilayer CVD coatings on high strength steels. Applied Surface Science, 2013. 280: p. 626-631.
[8] A. Weber, C. -P. Klages, M. E. Gross, R. M. Charatan and W. L. Brown, Formation Mechanism of TiN by Reaction of Tetrakis(dimethylamido)-Titanium with Plasma-Activated Nitrogen. Journal of The Electrochemical Society, 1995. 142(6): p. L79-L82.
[9] Y. S. Li, S. Shimada, H. Kiyono and A. Hirose, Synthesis of Ti-Al-Si-N nanocomposite films using liquid injection PECVD from alkoxide precursors. Acta Materialia, 2006. 54(8): p. 2041-2048.
[10] S. Abisset, F. Maury, R. Feurer, M. Ducarroir, M. Nadal and M. Andrieux ; Gas and plasma nitriding pretreatment of steel substrates before CVD growth of hard refractory coatings ; Thin Solid Films, 315 (1998) 179-185.
[11] FR 1562862 déposée le 18 décembre 2015.

## Revendications

1. Procédé de fabrication d'un composant nucléaire par la méthode de dépôt chimique en phase vapeur d'un composé organométallique par injection liquide directe (DLI-MOCVD), le composant nucléaire choisi parmi une gaine de combustible nucléaire, une grille d'espacement, un tube guide, un combustible à plaque ou une barre d'absorbant, comprenant :
- i) un support contenant un substrat à base d'un métal choisi parmi le zirconium, le titane, le vanadium, le molybdène ou leurs alliages de base (1), le substrat (1) étant revêtu ou non d'une couche intercalaire (3) positionnée entre le substrat (1) et au moins une couche protectrice (2) ;
- ii) ladite au moins une couche protectrice (2) revêtant ledit support et composée d'une matière protectrice comprenant du chrome choisie parmi un alliage de chrome, un carbure d'un alliage de chrome, un nitrure de chrome, un carbonitrure de chrome, un carbure mixte chrome silicium, un nitrure mixte chrome silicium, un carbonitrure mixte chrome silicium, ou leurs mélanges ;
le procédé comprenant les étapes successives suivantes :
a) vaporiser une solution mère contenant un solvant hydrocarboné dépourvu d'atome d'oxygène, un précurseur de type bis (arène) comprenant du chrome ; et contenant le cas échéant un précurseur additionnel, un inhibiteur d'incorporation de carbone ou leur mélange ; les précurseurs ayant une température de décomposition comprise entre 300 °C et 600 °C ;
b) dans un réacteur de dépôt chimique en phase vapeur dans lequel se trouve ledit support à recouvrir et dont l'atmosphère est à une température de dépôt comprise entre 300 °C et 600 °C et sous une pression de dépôt comprise entre 13 Pa et 7000 Pa ; introduire la solution mère vaporisée à l'étape a), ce qui provoque le dépôt de ladite au moins une couche protectrice (2) sur ledit support.

2. Procédé de fabrication d'un composant nucléaire selon la revendication 1, dans lequel le composant nucléaire comprend en outre un feuillard interne (4) placé sur la surface interne dudit support qui est la surface dudit support opposée au milieu extérieur au composant nucléaire ; le feuillard interne (4) étant déposé, à une température de dépôt comprise entre 200 °C et 400 °C, sur la surface interne dudit support par dépôt chimique en phase vapeur d'un composé organométallique (MOCVD) ou DLI-MOCVD avec pour précurseur(s) un amide de titane et en outre un précurseur comprenant du silicium, un précurseur comprenant de l'aluminium et/ou un additif liquide comprenant de l'azote si la matière composant le feuillard interne (4) comprend respectivement du silicium, de l'aluminium et/ou de l'azote.

3. Procédé de fabrication d'un composant nucléaire selon la revendication 1 ou 2, dans lequel le procédé comprend après l'étape b) :
c) réaliser sur ladite au moins une couche protectrice (2) au moins une étape choisie parmi une étape postérieure de traitement de nitruration ionique ou gazeuse, de siliciuration ionique ou gazeuse, de carbosiliciuration ionique ou gazeuse, de nitruration ionique ou gazeuse suivie d'une siliciuration ou carbosiliciuration ionique ou gazeuse.

4. Procédé de fabrication d'un composant nucléaire selon l'une quelconque des revendications précédentes, dans lequel la solution mère contient le précurseur de type bis (arène) comprenant du chrome, un précurseur comprenant du silicium en tant que précurseur additionnel ; de telle sorte, qu'à une température de dépôt comprise entre 450 °C et 500 °C, la matière protectrice comprenant un carbure mixte chrome silicium est obtenue.

5. Procédé de fabrication d'un composant nucléaire selon l'une quelconque des revendications précédentes, dans lequel la solution mère contient le précurseur de type bis (arène) comprenant du chrome, un précurseur comprenant du silicium en tant que précurseur additionnel, un précurseur liquide comprenant de l'azote en tant que précurseur additionnel étant présent dans la solution mère ou un précurseur gazeux comprenant de l'azote étant présent dans le réacteur de dépôt chimique en phase vapeur ; de telle sorte, qu'à une température de dépôt comprise entre 450 °C et 550 °C, la matière protectrice comprenant un nitrure mixte chrome silicium est obtenue en présence de l'inhibiteur ou la matière protectrice comprenant un carbonitrure mixte chrome silicium est obtenue en absence de l'inhibiteur.

6. Procédé de fabrication d'un composant nucléaire selon l'une quelconque des revendications précédentes, dans lequel le précurseur de type bis (arène) comprenant du chrome, le précurseur de type bis (arène) comprenant du vanadium, le précurseur de type bis (arène) comprenant du niobium ou le précurseur de type bis (arène) comprenant l'élément d'addition comprennent un élément M respectivement choisi parmi le chrome, le vanadium, le niobium ou l'élément d'addition ; l'élément M étant au degré d'oxydation zéro (M₀) afin de disposer d'un précurseur de type bis (arène) comprenant l'élément M₀.

7. Composant nucléaire choisi parmi une gaine de combustible nucléaire, une grille d'espacement, un tube guide, un combustible à plaque ou une barre d'absorbant, comprenant :
- i) un support contenant un substrat à base d'un métal choisi parmi le zirconium, le titane, le vanadium, le molybdène ou leurs alliages de base (1), le substrat (1) étant revêtu ou non d'une couche intercalaire (3) positionnée entre le substrat (1) et au moins une couche protectrice (2) ;
- ii) ladite au moins une couche protectrice (2) revêtant ledit support et composée d'une matière protectrice comprenant du chrome choisie parmi un alliage de chrome sauf si le substrat (1) est à base de zirconium, un carbure d'un alliage de chrome, un nitrure de chrome, un carbonitrure de chrome, un carbure mixte chrome silicium par exemple de type « phase MAX », un nitrure mixte chrome silicium, un carbonitrure mixte chrome silicium, ou leurs mélanges.

8. Composant nucléaire selon la revendication 7, dans lequel la couche intercalaire (3) comprend au moins une matière intercalaire choisie parmi le chrome, le tantale, le molybdène, le tungstène, le niobium, le vanadium, leurs alliages, un nitrure de titane, un carbonitrure de titane, un nitrure mixte titane silicium, un carbure mixte titane silicium, un carbonitrure mixte titane silicium, un nitrure mixte titane aluminium ou leurs mélanges.

9. Composant nucléaire selon la revendication 7 ou 8, dans lequel le composant nucléaire comprend en outre un feuillard interne (4) placé sur la surface interne dudit support, la surface interne dudit support étant la surface opposée au milieu extérieur au composant nucléaire ; la matière composant le feuillard interne (4) comprenant par exemple un nitrure de titane, un carbonitrure de titane, un nitrure mixte titane silicium, un carbure mixte titane silicium, un carbonitrure mixte titane silicium, un nitrure mixte titane aluminium ou leurs mélanges.

10. Composant nucléaire selon l'une quelconque des revendications 7 à 9, dans lequel ladite au moins une couche protectrice (2) est une couche protectrice externe (2A) qui revêt la surface externe dudit support qui est la surface dudit support faisant face au milieu extérieur au composant nucléaire ; et/ou, lorsque le composant nucléaire comprend un volume interne ouvert ou non, une couche protectrice interne (2B) qui revêt la surface interne dudit support revêtu ou non du feuillard interne (4).

11. Composant nucléaire selon l'une quelconque des revendications 7 à 10, dans lequel l'alliage de chrome est choisi parmi un alliage chrome/vanadium, un alliage chrome/niobium, un alliage chrome/vanadium/niobium ou un alliage chrome/aluminium ou le carbure de l'alliage de chrome est choisi parmi un carbure d'un alliage chrome/vanadium, un carbure d'un alliage chrome/niobium, un carbure d'un alliage chrome/vanadium/niobium ou un carbure d'un alliage chrome/aluminium.

12. Composant nucléaire selon l'une quelconque des revendications 7 à 11, dans lequel le carbure mixte chrome silicium, le carbonitrure mixte chrome silicium ou le nitrure mixte chrome silicium est amorphe.

13. Composant nucléaire selon l'une quelconque des revendications 7 à 12, dans lequel la matière protectrice est dopée avec un élément d'addition choisi parmi l'yttrium, l'aluminium, le vanadium, le niobium, le molybdène, le tungstène ou leurs mélanges, par exemple à une teneur de 1 % à 10 % atomique.

14. Composant nucléaire selon l'une quelconque des revendications 7 à 13, dans lequel ladite au moins une couche protectrice (2) a une structure telle qu'elle présente un gradient de composition et/ou une structure équiaxe.

15. Composant nucléaire selon l'une quelconque des revendications 7 à 14, dans lequel plusieurs couches protectrices (2) de composition identiques ou différentes forment respectivement un revêtement protecteur multicouche homogène, par exemple dans lequel le revêtement protecteur multicouche homogène comprend des couches protectrices (2) composées de l'alliage de chrome, ou un revêtement protecteur multicouche hétérogène, par exemple dans lequel le revêtement protecteur multicouche hétérogène comprend des couches protectrices (2) composées :
- de carbure mixte chrome silicium et de chrome, ou
- de carbure mixte chrome silicium et de nitrure de chrome, ou
- de nitrure mixte chrome silicium et de chrome, ou
- de nitrure mixte chrome silicium et de nitrure de chrome, ou
- de carbure mixte chrome silicium et de nitrure mixte chrome silicium.

16. Utilisation d'un composant nucléaire tel que défini par l'une quelconque des revendications 7 à 15, pour lutter contre l'oxydation et/ou l'hydruration, dans une atmosphère humide comprenant de l'eau ; ou pour lutter contre l'hydruration dans une atmosphère hydrogénée comprenant de l'hydrogène.

## Patentansprüche

1. Verfahren zur Herstellung einer nuklearen Komponente durch das Verfahren der chemischen Dampfabscheidung einer metallorganischen Verbindung durch direkte Flüssigkeitseinspritzung (DLI-MOCVD), wobei die nukleare Komponente ausgewählt ist aus einer Kernbrennstoffhülle, einem Abstandsgitter, einem Führungsrohr, einem Plattenbrennstoff oder einem Absorberstab, enthaltend:
- i) einen Träger, der ein Substrat auf Basis von Metall, ausgewählt aus Zirkonium, Titan, Vanadium, Molybdän und deren Basislegierungen (1), enthält, wobei das Substrat (1) gegebenenfalls mit einer Zwischenschicht (3) beschichtet ist, die zwischen dem Substrat (1) und zumindest einer Schutzschicht (2) angeordnet ist;
- ii) wobei die zumindest eine Schutzschicht (2) den Träger beschichtet und aus einem Schutzmaterial besteht, das Chrom enthält, ausgewählt aus einer Chromlegierung, einem Karbid einer Chromlegierung, einem Chromnitrid, einem Chromkarbonitrid, einem Chrom-Silizium-Mischkarbid, einem Chrom-Silizium-Mischnitrid, einem Chrom-Silizium-Mischkarbonitrid oder deren Gemischen;
wobei das Verfahren die nachstehenden, aufeinanderfolgenden Schritte umfasst:
a) Verdampfen einer Stammlösung, die ein sauerstoffatomfreies Kohlenwasserstofflösungsmittel, einen Vorläufer vom Typ Bis (Aren), der Chrom enthält; und gegebenenfalls einen zusätzlichen Vorläufer, einen Kohlenstoffeinlagerungsinhibitor oder deren Gemisch enthält; wobei die Vorläufer eine Zersetzungstemperatur zwischen 300°C und 600°C haben;
b) in einen Reaktor zur chemischen Dampfabscheidung, in dem sich der zu bedeckende Träger befindet und dessen Atmosphäre eine Abscheidungstemperatur zwischen 300°C und 600°C und einen Abscheidungsdruck zwischen 13 Pa und 7000 Pa aufweist, Einführen der in Schritt a) verdampften Stammlösung, wodurch die Abscheidung der zumindest einen Schutzschicht (2) auf dem Träger bewirkt wird.

2. Verfahren zur Herstellung einer nuklearen Komponente nach Anspruch 1, wobei die nukleare Komponente ferner eine Innenfolie (4) enthält, die auf der inneren Oberfläche des Trägers angeordnet ist, welche die der Umgebung außerhalb der nuklearen Komponente entgegengesetzte Oberfläche des Trägers ist; wobei die Innenfolie (4) bei einer Abscheidungstemperatur zwischen 200°C und 400°C auf der inneren Oberfläche des Trägers durch chemische Dampfabscheidung einer metallorganischen Verbindung (MOCVD) oder DLI-MOCVD mit einem Titanamid als Vorläufer und ferner einem Silizium enthaltenden Vorläufer, einem Aluminium enthaltenden Vorläufer und/oder einem Stickstoff enthaltenden flüssigen Additiv abgeschieden wird, wenn das die Innenfolie (4) bildende Material Silizium, Aluminium und/oder Stickstoff enthält.

3. Verfahren zur Herstellung einer nuklearen Komponente nach Anspruch 1 oder 2,
wobei das Verfahren nach Schritt b) umfasst:
c) Ausführen mindestens eines Schrittes auf der mindestens einen Schutzschicht (2), ausgewählt aus einem nachfolgenden Behandlungsschritt des ionischen oder gasförmigen Nitrierens, ionischen oder gasförmigen Silizidierens, ionischen oder gasförmigen Carbosilizidierens, ionischen oder gasförmigen Nitrierens, gefolgt von ionischem oder gasförmigem Silizidieren oder Carbosilizidieren.

4. Verfahren zur Herstellung einer nuklearen Komponente nach einem der vorangehenden Ansprüche,
wobei die Stammlösung den Vorläufer vom Typ Bis (Aren), der Chrom enthält, und einen Vorläufer, der Silizium als zusätzlichen Vorläufer enthält, enthält; so dass bei einer Abscheidungstemperatur zwischen 450°C und 500°C das Schutzmaterial erhalten wird, das ein Chrom-Silizium-Mischkarbid enthält.

5. Verfahren zur Herstellung einer nuklearen Komponente nach einem der vorangehenden Ansprüche,
wobei die Stammlösung den Vorläufer vom Typ Bis (Aren), der Chrom enthält, und einen Vorläufer, der Silizium als zusätzlichen Vorläufer enthält, enthält, wobei ein flüssiger Vorläufer, der Stickstoff als zusätzlichen Vorläufer enthält, in der Stammlösung vorhanden ist, oder ein gasförmiger Vorläufer, der Stickstoff enthält, im Reaktor der chemischen Dampfabscheidung vorhanden ist; so dass bei einer Abscheidungstemperatur zwischen 450°C und 550°C das Schutzmaterial, das ein Chrom-Silizium-Mischnitrid enthält, in Gegenwart des Inhibitors erhalten wird oder das Schutzmaterial, das ein Chrom-Silizium-Mischkarbonitrid enthält, bei Fehlen des Inhibitors erhalten wird.

6. Verfahren zur Herstellung einer nuklearen Komponente nach einem der vorangehenden Ansprüche, wobei der Vorläufer des Typs Bis (Aren), der Chrom enthält, der Vorläufer des Typs Bis (Aren), der Vanadium enthält, der Vorläufer des Typs Bis (Aren), der Niob enthält, oder der Vorläufer des Typs Bis (Aren), der das Additionselement enthält, ein Element M, ausgewählt aus Chrom, Vanadium Niob oder aus dem Additionselement, enthalten; wobei das Element M sich in der Oxidationsstufe Null (M₀) befindet, um einen Vorläufer des Typs Bis (Aren) bereitzustellen, der das Element M₀ enthält.

7. Nukleare Komponente, die ausgewählt ist aus einer Kernbrennstoffhülle, einem Abstandsgitter, einem Führungsrohr, einem Plattenbrennstoff oder einem Absorberstab, enthaltend:
- i) einen Träger, der ein Substrat auf Basis von Metall, ausgewählt aus Zirkonium, Titan, Vanadium, Molybdän und deren Basislegierungen (1), enthält, wobei das Substrat (1) gegebenenfalls mit einer Zwischenschicht (3) beschichtet ist, die zwischen dem Substrat (1) und zumindest einer Schutzschicht (2) angeordnet ist;
- ii) wobei die zumindest eine Schutzschicht (2) den Träger beschichtet und aus einem Schutzmaterial besteht, das Chrom enthält, ausgewählt aus einer Chromlegierung, außer dann, wenn das Substrat (1) auf Zirkonium-Basis besteht, einem Karbid einer Chromlegierung, einem Chromnitrid, einem Chromkarbonitrid, einem Chrom-Silizium-Mischkarbid, beispielsweise vom Typ "MAX-Phase", einem Chrom-Silizium-Mischnitrid, einem Chrom-Silizium-Mischkarbonitrid oder deren Gemischen.

8. Nukleare Komponente nach Anspruch 7,
wobei die Zwischenschicht (3) mindestens ein Zwischenmaterial, ausgewählt aus Chrom, Tantal, Molybdän, Wolfram, Niob, Vanadium, deren Legierungen, Titannitrid, Titankarbonitrid, Titan-Silizium-Mischnitrid, Titan-Silizium-Mischkarbid, Titan-Silizium-Mischkarbonitrid, Titan-Aluminium-Mischnitrid oder deren Gemischen, enthält.

9. Nukleare Komponente nach Anspruch 7 oder 8,
wobei die nukleare Komponente ferner eine Innenfolie (4) enthält, die auf der inneren Oberfläche des Trägers angeordnet ist, wobei die innere Oberfläche des Trägers die der Umgebung außerhalb der nuklearen Komponente entgegengesetzte Oberfläche ist; wobei das Material, aus dem die Innenfolie (4) besteht, beispielsweise Titannitrid, Titankarbonitrid, Titan-Silizium-Mischnitrid, Titan-Silizium-Mischkarbid, Titan-Silizium-Mischkarbonitrid, Titan-Aluminium-Mischnitrid oder deren Gemische enthält.

10. Nukleare Komponente nach einem der Ansprüche 7 bis 9,
wobei die zumindest eine Schutzschicht (2) eine äußere Schutzschicht (2A) ist, welche die äußere Oberfläche des Trägers bedeckt, nämlich die Oberfläche des Trägers, welche der Umgebung außerhalb der nuklearen Komponente gegenüberliegt; und/oder eine innere Schutzschicht (2B), welche die innere Oberfläche des gegebenenfalls mit der Innenfolie (4) beschichteten Trägers bedeckt, wenn die nukleare Komponente ein gegebenenfalls offenes Innenvolumen hat.

11. Nukleare Komponente nach einem der Ansprüche 7 bis 10,
wobei die Chromlegierung ausgewählt ist aus einer Chrom/Vanadium-Legierung, einer Chrom/Niob-Legierung, einer Chrom/Vanadium/Niob-Legierung oder einer Chrom/Aluminium-Legierung bzw. das Karbid der Chromlegierung ausgewählt ist aus einem Karbid einer Chrom/Vanadium-Legierung, einem Karbid einer Chrom/Niob-Legierung, einem Karbid einer Chrom/Vanadium/Niob-Legierung oder einem Karbid einer Chrom/AluminiumLegierung.

12. Nukleare Komponente nach einem der Ansprüche 7 bis 11,
wobei das Chrom-Silizium-Mischkarbid, das Chrom-Silizium-Mischkarbonitrid bzw. das Chrom-Silizium-Mischnitrid amorph ist.

13. Nukleare Komponente nach einem der Ansprüche 7 bis 12,
wobei das Schutzmaterial mit einem Additionselement dotiert ist, das aus Yttrium, Aluminium, Vanadium, Niob, Molybdän, Wolfram oder deren Gemischen ausgewählt ist, beispielsweise mit einem Gehalt von 1 bis 10 Atom-%.

14. Nukleare Komponente nach einem der Ansprüche 7 bis 13,
wobei die zumindest eine Schutzschicht (2) eine solche Struktur hat, dass sie einen Zusammensetzungsgradienten und/oder eine äquiaxiale Struktur aufweist.

15. Nukleare Komponente nach einem der Ansprüche 7 bis 14,
wobei mehrere Schutzschichten (2) gleicher oder unterschiedlicher Zusammensetzung jeweils eine homogene mehrschichtige Schutzbeschichtung bilden, wobei die homogene mehrschichtige Schutzbeschichtung beispielsweise Schutzschichten (2) aus der Chromlegierung aufweist, oder eine heterogene mehrschichtige Schutzbeschichtung bilden, wobei die heterogene mehrschichtige Schutzbeschichtung Schutzschichten (2) enthält, die zusammengesetzt sind aus:
- Chrom-Silizium-Mischkarbid und Chrom, oder
- Chrom-Silizium-Mischkarbid und Chromnitrid, oder
- Chrom-Silizium-Mischnitrid und Chrom, oder
- Chrom-Silizium-Mischnitrid und Chromnitrid, oder
- Chrom-Silizium-Mischkarbid und Chrom-Silizium-Mischnitrid.

16. Verwendung einer nuklearen Komponente nach einem der Ansprüche 7 bis 15 zur Bekämpfung der Oxidation und/oder Hydrierung in einer feuchten, Wasser enthaltenden Atmosphäre oder zur Bekämpfung der Hydrierung in einer Wasserstoffatmosphäre, die Wasserstoff enthält.

## Claims

1. Method for producing a nuclear component by the direct liquid injection metal organic chemical vapour deposition (DLI-MOCVD) method, the nuclear component being chosen from among a nuclear fuel cladding, a spacer grid, a guide tube, a plate fuel or an absorber rod, comprising:
- i) a supporting base containing a substrate based on a metal chosen from among zirconium, titanium, vanadium, molybdenum or the base alloys thereof (1), the substrate (1) being optionally clad with an interlayer (3) positioned between the substrate (1) and at least one protective layer (2);
- ii) said at least one protective layer (2) cladding said supporting base and composed of a protective material comprising chromium chosen from among a chromium alloy, a chromium alloy carbide, a chromium nitride, a chromium carbonitride, a mixed chromium-silicon carbide, a mixed chromium-silicon nitride, a mixed chromium-silicon carbonitride, or mixtures thereof;
the method comprising the following successive steps:
a) vaporising a stock solution containing a hydrocarbon solvent devoid of oxygen atoms, a bis(arene) type precursor comprising chromium; and containing where appropriate an additional precursor, a carbon incorporation inhibitor or mixture thereof; the precursors having a decomposition temperature between 300°C and 600°C;
b) in a chemical vapour deposition reactor wherein said supporting base to be clad is located and of which the atmosphere is at a deposition temperature between 300°C and 600°C and under a deposition pressure between 13 Pa and 7000 Pa; introducing the stock solution vaporised in step a), which induces the deposition of said at least one protective layer (2) on said supporting base.

2. Method for producing a nuclear component according to claim 1, wherein the nuclear component further comprises an inner strip (4) placed on the inner surface of said supporting base which is the surface of said supporting base opposite the external environment of the nuclear component; the inner strip (4) being deposited, at a deposition temperature between 200°C and 400°C, on the inner surface of said supporting base by metal organic chemical vapour deposition (MOCVD) or DLI-MOCVD with by way of precursor(s) a titanium amide and furthermore a precursor comprising silicon, a precursor comprising aluminium and/or a liquid additive comprising nitrogen if the material constituting the inner strip (4) comprises silicon, aluminium and/or nitrogen, respectively.

3. Method for producing a nuclear component according to claim 1 or 2, wherein the method comprises after step b):
c) carrying out on said at least one protective layer (2) at least one step chosen from among a subsequent step of treating by ion or gas nitriding, by ion or gas siliconising, by ion or gas carbosiliconising, by ion or gas nitriding followed by ion or gas siliconising or carbosiliconising.

4. Method for producing a nuclear component according to any one of the preceding claims, wherein the stock solution contains the bis(arene) type precursor comprising chromium, a precursor comprising silicon by way of additional precursor; such that, at a deposition temperature between 450°C and 500°C, the protective material comprising a mixed chromium-silicon carbide is obtained.

5. Method for producing a nuclear component according to any one of the preceding claims, wherein the stock solution contains the bis(arene) type precursor comprising chromium, a precursor comprising silicon by way of additional precursor, a liquid precursor comprising nitrogen by way of additional precursor being present in the stock solution or a gaseous precursor comprising nitrogen being present in the chemical vapour deposition reactor; such that, at a deposition temperature between 450°C and 550°C, the protective material comprising a mixed chromium-silicon nitride is obtained in the presence of the inhibitor or the protective material comprising a mixed chromium-silicon carbonitride is obtained in the absence of the inhibitor.

6. Method for producing a nuclear component according to any one of the preceding claims, wherein the bis(arene) type precursor comprising chromium, the bis(arene) type precursor comprising vanadium, the bis(arene) type precursor comprising niobium or the bis(arene) type precursor comprising the addition element comprise an element M respectively chosen from among chromium, vanadium, niobium or the addition element; the element M being in the zero oxidation state (M₀) so as to obtain a bis(arene) type precursor comprising the element M₀.

7. Nuclear component chosen from among a nuclear fuel cladding, a spacer grid, a guide tube, a plate fuel or an absorber rod, comprising:
- i) a supporting base containing a substrate based on a metal chosen from among zirconium, titanium, vanadium, molybdenum or the base alloys thereof (1), the substrate (1) being optionally clad with an interlayer (3) positioned between the substrate (1) and at least one protective layer (2);
- ii) said at least one protective layer (2) cladding said supporting base and composed of a protective material comprising chromium chosen from among a chromium alloy unless the substrate (1) is based on zirconium, a chromium alloy carbide, a chromium nitride, a chromium carbonitride, a mixed chromium-silicon carbide for example of "MAX phase" type, a mixed chromium-silicon nitride, a mixed chromium-silicon carbonitride, or mixtures thereof.

8. Nuclear component according to claim 7, wherein the interlayer (3) comprises at least one interlayer material chosen from among chromium, tantalum, molybdenum, tungsten, niobium, vanadium, alloys thereof, a titanium nitride, a titanium carbonitride, a mixed titanium-silicon nitride, a mixed titanium-silicon carbide, a mixed titanium-silicon carbonitride, a mixed titanium-aluminium nitride or mixtures thereof.

9. Nuclear component according to claim 7 or 8, wherein the nuclear component further comprises an inner strip (4) placed on the inner surface of said supporting base, the inner surface of said supporting base being the surface opposite the external environment of the nuclear component; the material constituting the inner strip (4) comprising for example a titanium nitride, a titanium carbonitride, a mixed titanium-silicon nitride, a mixed titanium-silicon carbide, a mixed titanium-silicon carbonitride, a mixed titanium-aluminium nitride or mixtures thereof.

10. Nuclear component according to any one of claims 7 to 9, wherein said at least one protective layer (2) is an outer protective layer (2A) cladding the outer surface of said supporting base which is the surface of said supporting base facing the external environment of the nuclear component; and/or, where the nuclear component comprises an optionally open inner volume, an inner protective layer (2B) cladding the inner surface of said supporting base optionally clad with the inner strip (4).

11. Nuclear component according to any one of claims 7 to 10, wherein the chromium alloy is chosen from among a chromium/vanadium alloy, a chromium/niobium alloy, a chromium/vanadium/niobium alloy or a chromium/aluminium alloy or the carbide of the chromium alloy is chosen from among a chromium/vanadium alloy carbide, a chromium/niobium alloy carbide, a chromium/vanadium/niobium alloy carbide or a chromium/aluminium alloy carbide.

12. Nuclear component according to any one of claims 7 to 11, wherein the mixed chromium-silicon carbide, the mixed chromium-silicon carbonitride or the mixed chromium-silicon nitride is amorphous.

13. Nuclear component according to any one of claims 7 to 12, wherein the protective material is doped with an addition element chosen from among yttrium, aluminium, vanadium, niobium, molybdenum, tungsten or mixtures thereof, for example at an atomic content of 1% to 10%.

14. Nuclear component according to any one of claims 7 to 13, wherein said at least one protective layer (2) has a structure such that it has a composition gradient and/or an equiaxed structure.

15. Nuclear component according to any one of claims 7 to 14, wherein several protective layers (2) of identical or different composition respectively form a homogenous multilayer protective coating, for example wherein the homogeneous multilayer protective coating comprises protective layers (2) composed of chromium alloy, or a heterogeneous multilayer protective coating, for example wherein the heterogeneous protective coating comprises protective layers (2) composed of:
- mixed chromium-silicon carbide and chromium, or
- mixed chromium-silicon carbide and chromium nitride, or
- mixed chromium-silicon nitride and chromium, or
- mixed chromium-silicon nitride and chromium nitride, or
- mixed chromium-silicon carbide and mixed chromium-silicon nitride.

16. Use of a nuclear component as defined by any one of claims 7 to 15, for countering oxidation and/or hydriding, in a wet atmosphere comprising water; or for countering hydriding in a hydrogenated atmosphere comprising hydrogen.
